# EUROPEAN PATENT SPECIFICATION

(11) **EP 2 078 302 B1**
(45) Date of publication and mention of the grant of the patent: **24.11.2010**
(21) Application number: 07865470.4
(22) Date of filing: 10.12.2007
(51) Int. Cl.: G11C 16/10, G11C 16/12, G11C 16/04

(54) **REDUCING PROGRAM DISTURB IN NON-VOLATILE STORAGE USING EARLY SOURCE-SIDE BOOSTING**
REDUKTION VON PROGRAMMSTÖRUNGEN IN EINEM NICHTFLÜCHTIGEN SPEICHER MIT FRÜHEM QUELLENSEITIGEM BOOSTING
RÉDUCTION DE LA PERTURBATION D'UN PROGRAMME DANS UNE MÉMOIRE NON VOLATILE À L'AIDE D'UNE AMPLIFICATION PRÉCOCE CÔTÉ SOURCE

(30) Priority: 12.12.2006 US 609804; 12.12.2006 US 609813
(43) Date of publication of application: 15.07.2009
(73) Proprietor: Sandisk Corporation, Milpitas, CA 95035 (US)
(72) Inventor: DONG, Yingda, c/o SanDisk Corporation, Milpitas, CA 95035 (US); LUTZE, Jeffrey W., San Jose, CA 95125 (US)
(74) Representative: Tothill, John Paul
(86) International application number: PCT/US2007/086981
(87) International publication number: WO 2008/073892

(56) References cited:
- WO-A-2005/104135
- US-A- 6 011 287
- US-A1- 2002 003 722

## Description

The present invention relates to non-volatile memory.

Semiconductor memory has become increasingly popular for use in various electronic devices. For example, non-volatile semiconductor memory is used in cellular telephones, digital cameras, personal digital assistants, mobile computing devices, non-mobile computing devices and other devices. Electrically Erasable Programmable Read Only Memory (EEPROM) and flash memory are among the most popular non-volatile semiconductor memories. With flash memory, also a type of EEPROM, the contents of the whole memory array, or of a portion of the memory, can be erased in one step, in contrast to the traditional, full-featured EEPROM.

Both the traditional EEPROM and the flash memory utilize a floating gate that is positioned above and insulated from a channel region in a semiconductor substrate. The floating gate is positioned between the source and drain regions. A control gate is provided over and insulated from the floating gate. The threshold voltage (V_{TH}) of the transistor thus formed is controlled by the amount of charge that is retained on the floating gate. That is, the minimum amount of voltage that must be applied to the control gate before the transistor is turned on to permit conduction between its source and drain is controlled by the level of charge on the floating gate.

Some EEPROM and flash memory devices have a floating gate that is used to store two ranges of charges and, therefore, the memory element can be programmed/erased between two states, e.g., an erased state and a programmed state. Such a flash memory device is sometimes referred to as a binary flash memory device because each memory element can store one bit of data.

A multi-state (also called multi-level) flash memory device is implemented by identifying multiple distinct allowed/valid programmed threshold voltage ranges. Each distinct threshold voltage range corresponds to a predetermined value for the set of data bits encoded in the memory device. For example, each memory element can store two bits of data when the element can be placed in one of four discrete charge bands corresponding to four distinct threshold voltage ranges.

Typically, a program voltage V_{PGM} applied to the control gate during a program operation is applied as a series of pulses that increase in magnitude over time. In one possible approach, the magnitude of the pulses is increased with each successive pulse by a predetermined step size, e.g., 0.2-0.4 V. V_{PGM} can be applied to the control gates of flash memory elements. In the periods between the program pulses, verify operations are carried out. That is, the programming level of each element of a group of elements being programmed in parallel is read between successive programming pulses to determine whether it is equal to or greater than a verify level to which the element is being programmed. For arrays of multi-state flash memory elements, a verification step may be performed for each state of an element to determine whether the element has reached its data-associated verify level. For example, a multi-state memory element capable of storing data in four states may need to perform verify operations for three compare points.

Moreover, when programming an EEPROM or flash memory device, such as a NAND flash memory device in a NAND string, typically V_{PGM} is applied to the control gate and the bit line is grounded, causing electrons from the channel of a cell or memory element, e.g., storage element, to be injected into the floating gate. When electrons accumulate in the floating gate, the floating gate becomes negatively charged and the threshold voltage of the memory element is raised so that the memory element is considered to be in a programmed state. More information about such programming can be found in U.S. Patent 6,859,397, titled "Source Side Self Boosting Technique For Non-Volatile Memory," and in U.S. Patent Application Publication 2005/0024939, titled "Detecting Over Programmed Memory," published February 3, 2005.

However, program disturb can occur at inhibited NAND strings during programming of other NAND strings, and sometimes at the programmed NAND string itself. Program disturb occurs when the threshold voltage of an unselected non-volatile storage element is shifted due to programming of other non-volatile storage elements. Program disturb can occur on previously programmed storage elements as well as erased storage elements that have not yet been programmed.
US 6,011,287, over which the claims have been characterised, discloses a NAND EEPROM to which the "local self-boosting system" is applied. US 2002/0003722 discloses a method for programming NAND flash memory. WO 2005/104135 discloses a method for programming NAND flash memory so as to reduce or avoid program disturb.

The present invention addresses the above and other issues by providing a method for reducing program disturb in non-volatile storage.

According to a first aspect of the invention, there is provided a method for programming non-volatile storage having a NAND flash memory structure as claimed in claim 1. This approach can be used, e.g., with a boosting mode in which an isolation word line tends to isolate the first and second regions from one another.

In one embodiment, the boosting of the first region includes applying a pass voltage to at least one word line on the source side of the selected word line, and the boosting of the second region includes applying a pass voltage to at least one other word line on the drain side of the selected word line.

The set of non-volatile storage elements can be provided in at least one NAND string which extends between a source side select gate and a drain side select gate, in which case the method further includes maintaining the source side select gate and the drain side select gate closed during the boosting of the first and second regions.

Further, a program voltage can be applied to the at least one non-volatile storage element via the selected word line during the boosting of the first and second regions. In one approach, the program voltage is applied initially at a first level and subsequently at a higher second level.
According to a second aspect of the invention, there is provided a non-volatile storage system having a NAND flash memory structure as claimed in claim 7.
Various embodiments of the present invention will now be described, by way of example only, and with reference to the accompanying drawings in which:

FIG. 1 is a top view of a NAND string.

FIG. 2 is an equivalent circuit diagram of the NAND string of FIG. 1.

FIG. 3 is a block diagram of an array of NAND flash storage elements.

FIG. 4 depicts a cross-sectional view of an unselected NAND string showing programmed and erased areas.

FIG. 5 depicts an erased area self-boosting mode implemented via a plurality of word lines.

FIG. 6 depicts a first revised erased area self-boosting mode implemented via a plurality of word lines.

FIG. 7a depicts a second revised erased area self-boosting mode implemented via a plurality of word lines.

FIG. 7b depicts a third revised erased area self-boosting mode implemented via a plurality of word lines.

FIG. 8 depicts a delay between the start of source side boosting and the start of drain side boosting as a function of selected word line position.

FIG. 9 depicts a time line showing word line voltages when source side boosting is initiated before drain side boosting.

FIG. 10 depicts a process for switching a boost mode during programming based on a selected word line position.

FIG. 11 is a block diagram of an array of NAND flash storage elements.

FIG. 12 is a block diagram of a non-volatile memory system using single row/column decoders and read/write circuits.

FIG. 13 is a block diagram of a non-volatile memory system using dual row/column decoders and read/write circuits.

FIG. 14 is a block diagram depicting one embodiment of a sense block.

FIG. 15 illustrates an example of an organization of a memory array into blocks for an all bit line memory architecture or for an odd-even memory architecture.

FIG. 16 depicts an example set of threshold voltage distributions.

FIG. 17 depicts an example set of threshold voltage distributions.

FIGs. 18a-c show various threshold voltage distributions and describe a process for programming non-volatile memory.

FIG. 19 is a flow chart describing one embodiment of a process for programming non-volatile memory.

FIG. 20 depicts an example pulse train applied to the control gates of non-volatile storage elements during programming.

The present invention provides a method for reducing program disturb in non-volatile storage.

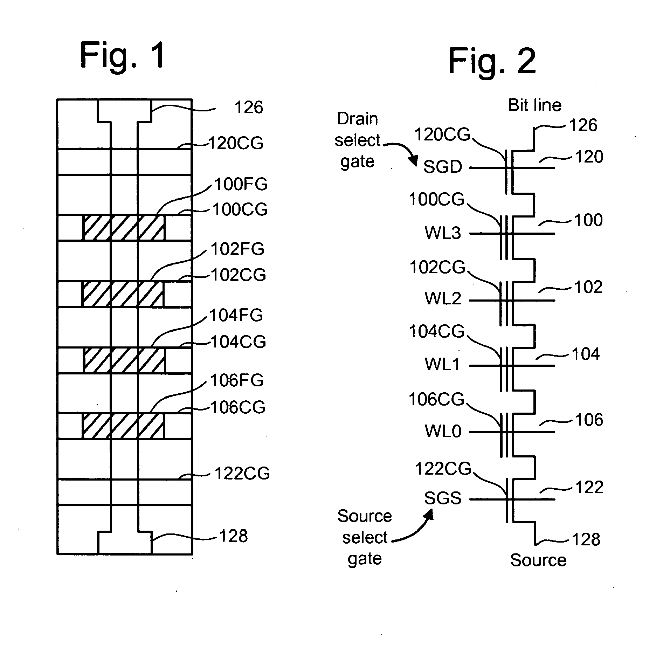

A memory system suitable for implementing the present invention uses the NAND flash memory structure, which includes arranging multiple transistors in series between two select gates. The transistors in series and the select gates are preferred to as a NAND string. FIG. 1 is a top view showing one NAND string. FIG. 2 is an equivalent circuit thereof. The NAND string depicted in FIGs. 1 and 2 includes four transistors, 100, 102, 104 and 106, in series and sandwiched between a first select gate 120 and a second select gate 122. Select gate 120 gates the NAND string connection to bit line 126. Select gate 122 gates the NAND string connection to source line 128. Select gate 120 is controlled by applying the appropriate voltages to control gate 120CG. Select gate 122 is controlled by applying the appropriate voltages to control gate 122CG. Each of the transistors 100, 102, 104 and 106 has a control gate and a floating gate. Transistor 100 has control gate 100CG and floating gate 100FG. Transistor 102 includes control gate 102CG and floating gate 102FG. Transistor 104 includes control gate 104CG and floating gate 104FG. Transistor 106 includes a control gate 106CG and floating gate 106FG. Control gate 100CG is connected to (or is) word line WL3, control gate 102CG is connected to word line WL2, control gate 104CG is connected to word line WL1, and control gate 106CG is connected to word line WL0. In one embodiment, transistors 100, 102, 104 and 106 are each storage elements, also referred to as memory cells. In other embodiments, the storage elements may include multiple transistors or may be different than that depicted in FIGs. 1 and 2. Select gate 120 is connected to select line SGD. Select gate 122 is connected to select line SGS.

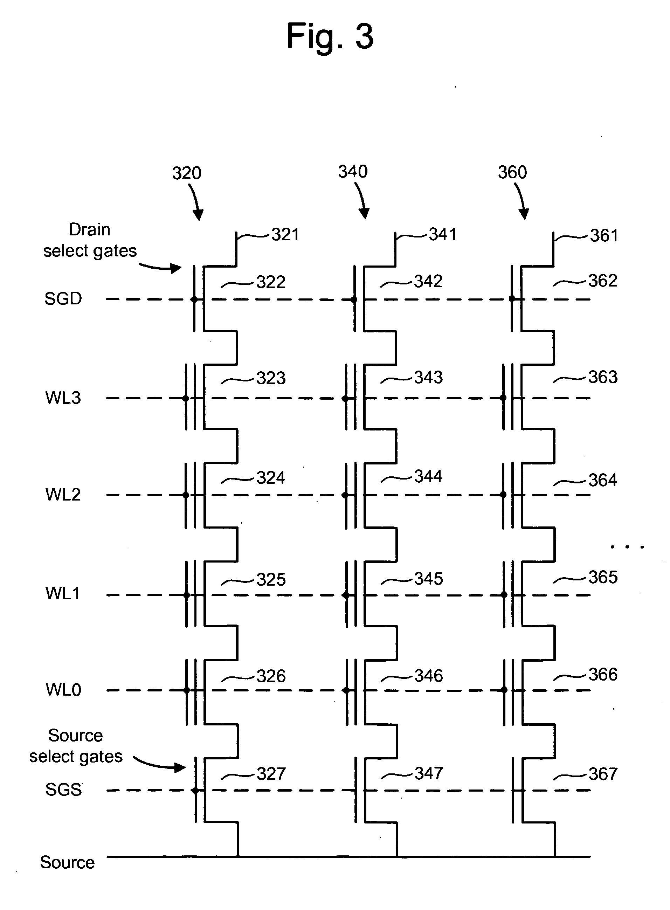

FIG. 3 is a circuit diagram depicting three NAND strings. A typical architecture for a flash memory system using a NAND structure will include several NAND strings. For example, three NAND strings 320, 340 and 360 are shown in a memory array having many more NAND strings. Each of the NAND strings includes two select gates and four storage elements. While four storage elements are illustrated for simplicity, modem NAND strings can have up to thirty-two or sixty-four storage elements, for instance.

For example, NAND string 320 includes select gates 322 and 327, and storage elements 323-326, NAND string 340 includes select gates 342 and 347, and storage elements 343-346, NAND string 360 includes select gates 362 and 367, and storage elements 363-366. Each NAND string is connected to the source line by its select gates (e.g., select gates 327, 347 or 367). A selection line SGS is used to control the source side select gates. The various NAND strings 320, 340 and 360 are connected to respective bit lines 321, 341 and 361, by select transistors in the select gates 322, 342, 362, etc. These select transistors are controlled by a drain select line SGD. In other embodiments, the select lines do not necessarily need to be in common among the NAND strings; that is, different select lines can be provided for different NAND strings. Word line WL3 is connected to the control gates for storage elements 323, 343 and 363. Word line WL2 is connected to the control gates for storage elements 324, 344 and 364. Word line WL1 is connected to the control gates for storage elements 325, 345 and 365. Word line WL0 is connected to the control gates for storage elements 326, 346 and 366. As can be seen, each bit line and the respective NAND string comprise the columns of the array or set of storage elements. The word lines (WL3, WL2, WL1 and WL0) comprise the rows of the array or set. Each word line connects the control gates of each storage element in the row. Or, the control gates may be provided by the word lines themselves. For example, word line WL2 provides the control gates for storage elements 324, 344 and 364. In practice, there can be thousands of storage elements on a word line.

Each storage element can store data. For example, when storing one bit of digital data, the range of possible threshold voltages (V_{TH}) of the storage element is divided into two ranges which are assigned logical data "1" and "0." In one example of a NAND type flash memory, the V_{TH} is negative after the storage element is erased, and defined as logic "1." The V_{TH} after a program operation is positive and defined as logic "0." When the V_{TH} is negative and a read is attempted, the storage element will turn on to indicate logic "1" is being stored. When the V_{TH} is positive and a read operation is attempted, the storage element will not turn on, which indicates that logic "0" is stored. A storage element can also store multiple levels of information, for example, multiple bits of digital data. In this case, the range of V_{TH} value is divided into the number of levels of data. For example, if four levels of information are stored, there will be four V_{TH} ranges assigned to the data values "11", "10", "01", and "00." In one example of a NAND type memory, the V_{TH} after an erase operation is negative and defined as "11". Positive V_{TH} values are used for the states of "10", "01", and "00." The specific relationship between the data programmed into the storage element and the threshold voltage ranges of the element depends upon the data encoding scheme adopted for the storage elements. For example, U.S. Patent No. 6,222,762 and U.S. Patent Application Pub. 2004/0255090 describe various data encoding schemes for multi-state flash storage elements.

Relevant examples of NAND type flash memories and their operation are provided in U.S. Patent Nos. 5,386,422, 5,522,580, 5,570,315, 5,774,397, 6,046,935, 6,456,528 and 6,522,580

When programming a flash storage element, a program voltage is applied to the control gate of the storage element and the bit line associated with the storage element is grounded. Electrons from the channel are injected into the floating gate. When electrons accumulate in the floating gate, the floating gate becomes negatively charged and the V_{TH} of the storage element is raised. To apply the program voltage to the control gate of the storage element being programmed, that program voltage is applied on the appropriate word line. As discussed above, one storage element in each of the NAND strings share the same word line. For example, when programming storage element 324 of FIG. 3, the program voltage will also be applied to the control gates of storage elements 344 and 364.

However, program disturb can occur at inhibited NAND strings during programming of other NAND strings, and sometimes at the programmed NAND string itself. Program disturb occurs when the threshold voltage of an unselected non-volatile storage element is shifted due to programming of other non-volatile storage elements. Program disturb can occur on previously programmed storage elements as well as erased storage elements that have not yet been programmed. Various program disturb mechanisms can limit the available operating window for non-volatile storage devices such as NAND flash memory.

For example, if NAND string 320 is inhibited (e.g., it is an unselected NAND string which does not contain a storage element which is currently being programmed) and NAND string 340 is being programmed (e.g., it is a selected NAND string which contains a storage element which is currently being programmed), program disturb can occur at NAND string 320. For example, if a pass voltage, V_{PASS}, is low, the channel of the inhibited NAND string is not well boosted, and a selected word line of the unselected NAND string can be unintentionally programmed. In another possible scenario, the boosted voltage can be lowered by Gate Induced Drain Leakage (GIDL) or other leakage mechanisms, resulting in the same problem. Other effects, such as shifts in the charge stored in a programmed storage element due to capacitive coupling between storage elements, can also be problematic.

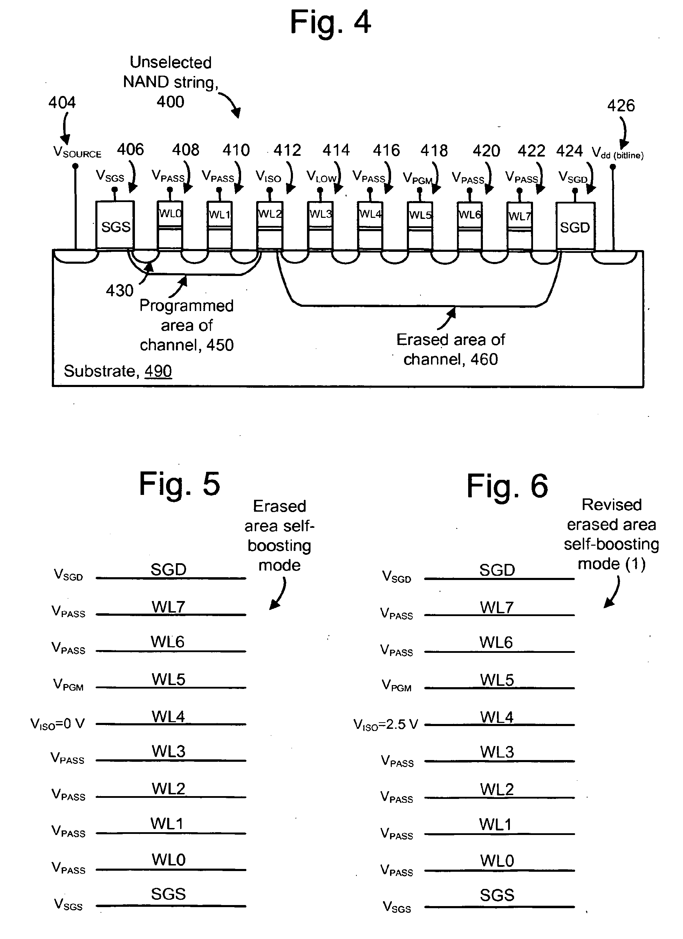

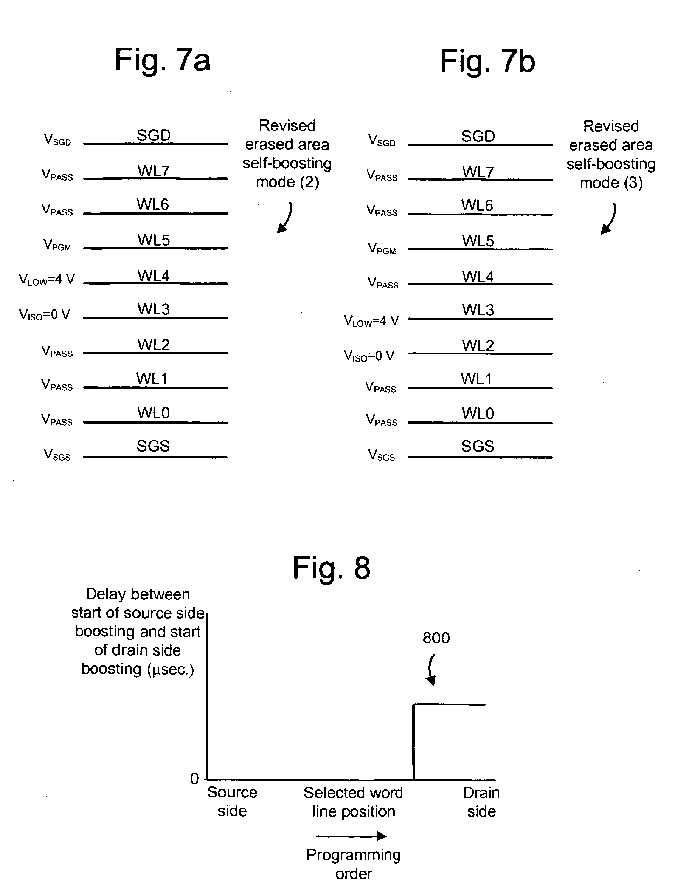

FIG. 4 depicts a cross-sectional view of an unselected NAND string showing programmed and erased areas with revised erased area self-boosting (REASB), such as depicted in FIG. 7b. The view is simplified and not to scale. The NAND string 400 includes a source-side select gate 406, a drain-side select gate 424, and eight storage elements 408, 410, 412, 414, 416, 418, 420 and 422, formed on a substrate 490. The components can be formed on an n-well region which is on a p-well region of the substrate. The p-well can in turn be formed on a p-substrate region. A source supply line 404 with a potential of V_{SOURCE} is provided in addition to a bit line 426 with a potential of V_{dd (bit line)}. During programming, V_{PGM} is provided on a selected word line, in this case, WL5, which is associated with a selected storage element 418. Further, recall that the control gate of a storage element may be provided as a portion of the word line. For example, WL0, WL1, WL2, WL3, WL4, WL5, WL6 and WL7 can extend via the control gates of storage elements 408, 410, 412, 414, 416, 418, 420 and 422, respectively.

In one example boosting scheme, when storage element 418 is the selected storage element, a relatively low voltage, V_{LOW}, e.g., 4 V, is applied to a neighboring source-side word line (WL3), while an isolation voltage, V_{ISO}, e.g., 0-2.5 V, is applied to another source-side word line (WL2), referred to as an isolation word line and V_{PASS} is applied to the remaining word lines associated with NAND string 400 (i.e., WL0, WL1, WL4, WL6 and WL7). V_{SGS} is applied to the select gate 406 and V_{SGD} is applied to the select gate 424.

Assuming programming of storage elements along the NAND string 400 progresses from storage element 408 to storage element 422, when storage elements associated with WL5 in other NAND strings are being programmed, storage elements 408-416 will already have been programmed, and storage elements 420 and 422 will not yet have been programmed. Note that storage element 418 is not programmed when the NAND string 400 is inhibited, in this example, even though a program voltage is applied on WL5. Thus, all or some of storage elements 408-416 will have electrons programmed into and stored in their respective floating gates, and storage elements 420 and 422 can be erased or partially programmed, depending on the programming mode. For example, the storage elements 420 and 422 may be partially programmed when they have been previously programmed in the first step of a two-step programming technique.

With the EASB or REASB boosting mode, V_{ISO} is applied to one or more source-side neighbors of the selected word line and is sufficiently low to isolate programmed and erased channel areas in the substrate, at some point after boosting is initiated. That is, a channel area 450 of the substrate on a source-side of the unselected NAND string 400 is isolated from a channel area 460 on a drain-side of the unselected NAND string 400. The source side can also be considered to be a programmed side since most or all of the associated storage elements have been programmed, while the drain side can also be considered to be an unprogrammed side since the associated storage elements have not yet been programmed. Further, the channel area 450 is a first boosted region of the substrate 490 which is boosted by the application of V_{PASS} on WL0 and WL1, while the channel area 460 is a second boosted region of the substrate 490 which is boosted mainly by the application of V_{PGM} on WL5 and V_{PASS} on WL4, WL6 and WL7. Since V_{PGM} dominates, the erased area 460 will experience relatively higher boosting than the programmed area 450. Moreover, the channel boosting may be provided for a time period before V_{PGM} is applied, at which time the channel areas 450 and 460 are similarly boosted.

However, program disturb tends to happen on high word lines (e.g., between WL24 and WL31 on a 32-word line NAND memory device) when V_{PASS} is relatively low, e.g., 8 V or less. Note that the highest word line, WL31, is also susceptible to this kind of program disturb failure, although it normally fares better than the other affected word lines (e.g., WL24-WL30) because, when WL31 is selected for programming, the drain side channel capacitance is small. As a result, V_{PGM} contributes more to the channel boosting. Generally, the program disturb failure is problematic for approximately the highest 25% of the word lines. For example, for a 64-word line NAND memory device, WL48-WL63 will have a similar program disturb failure problem. This is true because this kind of program disturb failure happens when the source side channel capacitance becomes significantly larger than drain side channel capacitance by a certain proportion.

For example, when REASB mode is used for channel boosting, the inhibited NAND string is separated into two regions (source side and drain side) and disturbs are caused by insufficient boosting in the drain side channel. In particular, evidence indicates that the low boosting potential on the drain side of the channel is caused by charge leakage from the drain to the source side during the initial stage of the boosting before the isolation storage element is completely off. For example, with storage element 418 as the currently selected storage element, storage element 412 as the isolation storage element may not be completed off when boosting is initiated by applying V_{PASS} to the other word lines. This leakage lowers the drain side channel boosting potential. And, since the to-be-programmed storage element (e.g., storage element 418) is located on the drain side of the NAND string, the low drain side channel potential can directly cause an insufficient boosting type of program disturb failure. Moreover, experimental data shows that these program disturb failures are particularly prevalent when the two storage elements on WL2 and WL3 (e.g., on WLn-3 and WLn-2 when WLn represents the selected word line) are both in the erased state.

To solve this problem, we propose boosting up the source side channel potential before boosting up the drain side channel potential. This approach has three benefits of increasing the drain side boosting efficiency. First, after source side boosting is initiated, the isolation storage element is more likely to be cut off when the drain side starts to boost afterwards. This can significantly reduce or even remove the electrons flowing from the source side to the drain side during the initial stage of channel boosting. Second, during the source side boosting, some electrons will flow in a leakage current from the drain side channel to the source side channel before the isolation storage element cuts off. This effectively adds positive charges (holes) in the drain side channel, as a result of which the drain side boosting becomes easier. Third, the proposed boosting approach reverses the lateral field direction during the initial stage of the drain side channel boosting, so that, even if the isolation storage element is still not completely turned off when the drain side boosting is initiated, the electrons will leak from the drain side to the source side. This can only increase the drain side channel potential instead of lowering it.

The validity of this approach is confirmed by observations which indicate that when a higher V_{PASS} is used to boost the source side channel vs. boosting the drain side channel, the drain side channel potential becomes higher and the disturb failures decrease. Measurements also indicate that after boosting becomes stable, the isolation storage element is sufficiently cut off. The fact that a higher V_{PASS} on the source side of the selected word line can improve drain side boosting potential likely can be explained as follows. When boosting just starts, the channel potentials on the source and drain sides both increase, but because the source side channel is not pre-charged, and the source side storage elements are already heavily programmed, the drain side channel potential will be higher than that in the source side. Specifically, many storage elements on the source side are already programmed, and therefore have V_{TH}>0 V. During one type of pre-charge, 0 V is applied on all the word lines, as a result of which the programmed storage elements on the source side cannot be turned on, and V_{dd} on the bit line can not be transferred into the source side channel. Further all drain side storage elements are erased (V_{TH}<0), and therefore they are turned on during pre-charge and can transfer V_{dd} into the drain side channel. As a result, the source side channel does not get pre-charged, while drain side channel does.

Thus, when the boosting just starts, the source side channel potential is still not high enough to cut off the isolation storage element. During a short period of time, electrons will flow from the source side to the drain side until the isolation storage element is off.

Additionally, when the selected word line is a higher word line, e.g., a word line close to the drain side of a set of storage elements, the drain side channel capacitance is relatively small, and the charge leakage can significantly lower the final drain side channel boosting potential. As a result, this kind of disturb failure tends to be more prevalent when the selected word lines are higher word lines. If a higher V_{PASS} is used on the source side word lines, the initial channel potential difference between the source and drain sides becomes smaller, so that the lateral field across the isolation storage element is weaker. As a result, the initial boosting leakage current from the drain to the source side will be smaller, and there will be less boosting potential loss in the drain side channel. However, a high V_{PASS} can cause V_{PASS} disturb on the erased storage elements on the source side and can exacerbate another fail mode which involves drain side hot electron injection disturb in channels being programmed. Due to these two reasons, it is not good to increase V_{PASS} on the source side channel. On the other hand, if V_{PASS} is too low, boosting in the channel will be insufficient to prevent program disturb. The boosting approach described herein reduces program disturb without the need to adjust V_{PASS}.

FIG. 5 depicts an erased area self-boosting mode implemented via a plurality of word lines. Generally, various types of boosting modes have been developed to combat program disturb. During programming of storage elements on a selected word line, the boosting modes are implemented by applying a set of voltages to unselected word lines which are in communication with storage elements which are not currently being programmed. The storage elements which are being programmed are associated with selected NAND strings while other storage elements are associated with unselected NAND strings. Program disturb generally involves storage elements in the unselected NAND strings.

In this example, there are eight word lines, e.g., control lines, labeled WL0 through WL7, a source-side select gate control line labeled SGS and a drain-side select gate control line labeled SGD. A set of voltages which is applied to the control lines is also depicted. WL5 is designated as the selected word line as an illustration. Programming typically proceeds one word line at a time, from the source side to the drain side of a NAND string. The voltages which are applied include V_{SGS}, which is applied to the source-side select gate control line SGS, a pass voltage, V_{PASS,} which is applied to each of the unselected word lines, WL0-WL3, WL6 and WL7, a program voltage, V_{PGM}, which is applied to the selected word line WL5, an isolation voltage V_{ISO} which is applied to WL4, the word line which is adjacent to the selected word line on the source side, and V_{SGD}, which is applied via the drain-side select gate control line SGD. Typically, V_{SGS} is 0 V so that the source-side select gate is off, when a source supply voltage V_{SOURCE} is about 2.5 V. V_{SGD} is about 2.5 V so that the drain-side select gate is on for the selected NAND strings, due to application of a corresponding low bit line voltage V_{BL} such as 0-1 V. The drain-side select gate is off for the unselected/inhibited NAND strings, due to application of a corresponding higher V_{BL} such as 1.5-3 V.

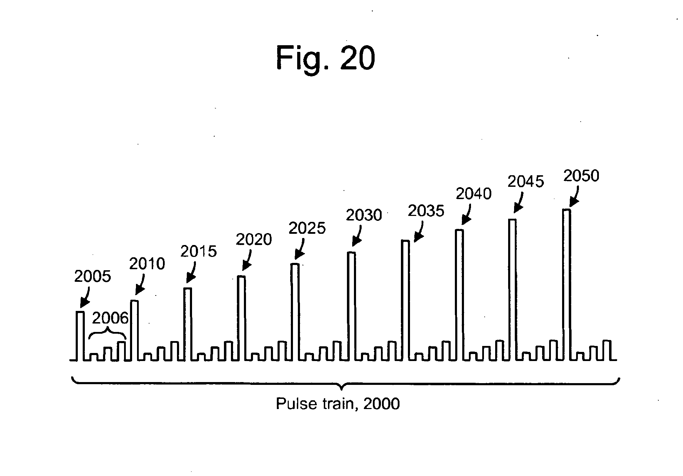

Additionally, V_{PASS} can be about 7-10 V and V_{PGM} can vary from about 12-20 V. In one programming scheme, a pulse train of program voltages is applied to the selected word line. See FIG. 20. The amplitude of each successive program pulse in the pulse train increases in a staircase manner, typically by about 0.3-0.5 V per pulse. Further, verify pulses can be applied between program pulses to verify whether the selected storage elements have reached a target programming condition. Note also that each individual program pulse can have a fixed amplitude, or can have a varying amplitude. For example, some programming schemes apply a pulse with an amplitude which varies like a ramp or staircase. Any type of program pulse can be used.

With WL5 as the programmed word line, and programming proceeding from the source side to the drain side of each NAND string, the storage elements associated with WL0-WL4 will have already been programmed and the storage elements associated with WL6 and WL7 will be erased when the storage elements on WL5 are being programmed. The pass voltages on the unselected word lines couple to the channels associated with the unselected NAND strings, causing a voltage to exist in the channels of the unselected NAND strings which tends to reduce program disturb by lowering the voltage across the tunnel oxide of the storage elements.

FIG. 6 depicts a first revised erased area self-boosting mode implemented via a plurality of word lines. In one approach, the first REASB mode is depicted by example word lines WL0-WL7 which communicate with a set of storage elements arranged in NAND strings. REASB is similar to EASB but applies a small isolation voltage, V_{ISO}, such as 2.5 V, instead of 0 V, to the word line which is adjacent to the selected word line on the source side. In this example, WL5 is the selected word line and WL4 is the adjacent word line. The remaining unselected word lines receive V_{PASS}.

FIG. 7a depicts a second revised erased area self-boosting mode implemented via a plurality of word lines. In one approach, the second REASB mode is depicted by example word lines which communicate with a set of storage elements arranged in NAND strings. In this case, an isolation voltage, V_{ISO}, is applied to WL3, and a low voltage, V_{LOW}, which is between V_{ISO} and V_{PASS}, is applied to WL4, where WL5 is the selected word line. V_{LOW} can also be considered to be an isolation voltage. In this approach, V_{LOW} serves as an intermediate voltage so that there is not an abrupt voltage change in the channel between the selected word line (WL5) and the adjacent source side word line (WL4). For example, V_{LOW} may be, e.g., 4 V and V_{ISO} may be, e.g., 0 V or 2.5 V. The remaining unselected word lines receive V_{PASS}. Various other approaches can be used as well. For example, there may be isolation voltages on three adjacent source-side word lines (e.g., WL2-WL4).

FIG. 7b depicts a third revised erased area self-boosting mode implemented via a plurality of word lines. In one approach, the third REASB mode is depicted by example word lines which communicate with a set of storage elements arranged in NAND strings. In this case, the source-side word line (WL4) adjacent to the selected word line (WL5) receives V_{PASS}, the next word line (WL3) receives V_{LOW} and the next word line after that (WL2) receives V_{ISO}. The remaining unselected word lines receive V_{PASS}. This boosting mode is also discussed in connection with FIG. 4. V_{PASS} is applied to a first group of storage elements associated with WL0 and WL1, where the first group is adjacent to the source side select gate. Also, V_{PASS} is applied to a second group of storage elements associated with WL6 and WL7, where the second group is adjacent to the drain side select gate.

FIG. 8 depicts a delay between the start of source side boosting and the start of drain side boosting as a function of selected word line position. In one approach, it is proposed that, at the initiation of boosting, the source side word line voltages are ramped up to V_{PASS} while the drain side word line voltages remain at 0 V, and after a delay, the drain side word line voltages are also ramped up to V_{PASS}. In other words, the source side channel potential of the substrate on which the storage elements are formed is boosted early relative to the drain side channel potential. The programming order proceeds generally word line-by-word line from the source side of a set of storage elements to a drain side of the set of storage elements. Further, the programming can be single pass or multi-pass. The horizontal axis depicts the selected word line position and the vertical axis depicts a delay between the start of the source side boosting (on a source side of the selected word line) and a start of the drain side boosting (on a drain side of the selected word line). As indicated by the curve 800, a delay of 0 µsec. can be used when the selected word line is close to the source side or generally at a mid-range, while a non-zero delay can be used when the selected word line is close to the drain side. In one example implementation, a delay of a few microseconds such as 3-4 µsec. is used when the selected word line is WL24-WL31 on a 32-word line NAND memory device, or otherwise approximately in the highest 25% of the word lines. The delay is a relatively short period which is sufficient to ensure than the isolation storage element is off.

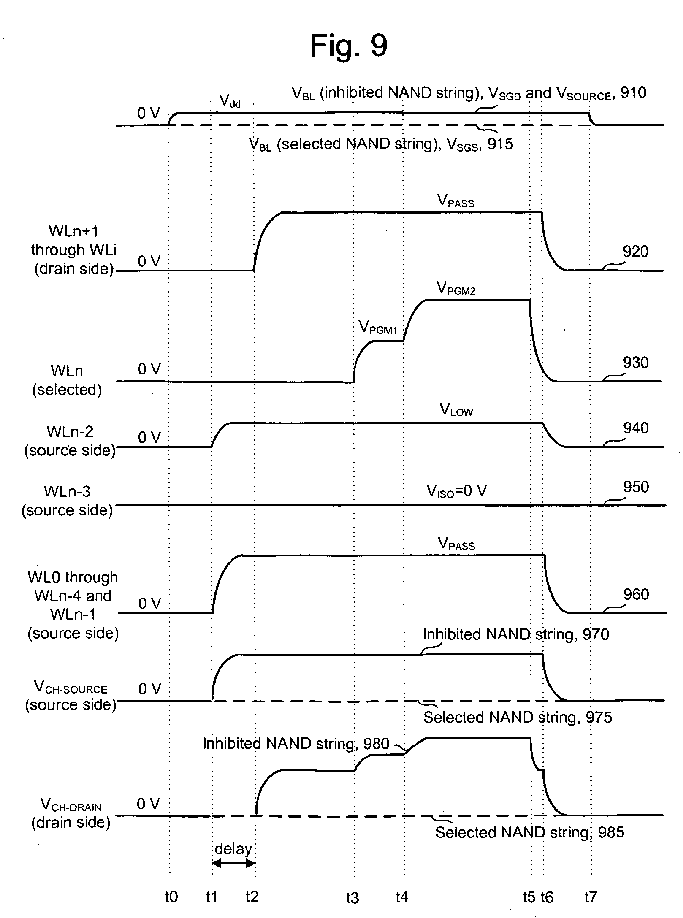

FIG. 9 depicts a time line showing word line voltages when source side boosting is initiated before drain side boosting. The time period shown depicts a single cycle of boosting and programming using a programming pulse. This cycle is typically followed by a sequence of verify pulses to determine if the storage elements have reached a desired programming state. The cycle of boosting and programming is then repeated using another programming pulse, typically at a stepped-up amplitude. See FIG. 20. Note also that the time period shown may be preceded by a pre-charge period in which the drain side channel is boosted by a bit line voltage V_{dd} which is transferred to the channel by opening the drain select gate. Typically, 0 V is applied to the word lines during pre-charging. However, pre-charging is not needed to realize benefits from early source side boosting.

Along the bottom of the time line are time points t0-t7. Time point t0 denotes the start of a boosting and programming cycle. Time point t1 denotes the initiation of boosting on the source side of the selected word line. Time point t2 denotes the initiation of boosting on the drain side of the selected word line. Time point t3 denotes the initiation of a programming voltage, e.g., the first step of a two-step programming voltage. Time point t4 denotes the initiation of the second step of the programming voltage. Time point t5 denotes the termination of the programming voltage. Time point t6 denotes the termination of the boosting voltages. Time point t7 denotes the termination of the boosting and programming cycle.

In particular, at t0, as indicated by waveform 910, the bit line voltage, V_{BL}, for the inhibited (unselected) NAND strings and the drain select gate voltage, V_{SGD}, are increased from 0 V to V_{dd}, e.g., 2.5 V. This ensures that the drain select gate for inhibited NAND strings remains closed. Also, the source voltage, V_{SOURCE}, increases from 0 V to V_{dd}. With the source select gate voltage, V_{SGS}, at 0 V (waveform 915), this ensures that the source select gate for all NAND strings remains closed. For selected NAND strings, V_{BL}=0 so that, with V_{SGD}=V_{dd}, the drain select gate is open to allow programming to occur. The example provided corresponds to the revised erased area boosting scheme of FIG. 7b. However, essentially any type of boosting scheme which uses one or more source side isolation word lines may be used.

Waveform 920 depicts the voltage (V_{PASS}) applied to the word lines on the drain side of the selected word line. WLi denotes the ith or highest word line and WLn+1 denotes the word line adjacent to the selected word line (WLn) on the drain side. Waveform 930 depicts programming voltages (V_{PGM1} and V_{PGM2}) applied to the selected word line (WLn). Waveform 940 depicts the voltage (V_{LOW}) applied to a word line (WLn-2) which is two word lines away from the selected word line on the source side. Waveform 950 depicts the isolation voltage (V_{ISO}) applied to a word line (WLn-3) which is three word lines away from the selected word line on the source side. Waveform 960 depicts the voltage (V_{PASS}) applied to the remaining unselected word lines, including a word line (WLn-1) which is adjacent to the selected word line on the source side, and word lines (WL0 through WLn-4) which extend from the first word line (WL0) to a word line (WLn-4) which is four word lines away from the selected word line on the source side. Waveforms 970 and 975 depict the channel potential (V_{CH-SOURCE}) which exists in the channel of the substrate on the source side of the selected word line, for the inhibited and selected NAND strings, respectively. Waveforms 980 and 985 depict the channel potential (V_{CH-DRAIN}) which exists in the channel of the substrate on the drain side of the selected word line, for the inhibited and selected NAND strings, respectively. Note how V_{CH-DRAINT} (waveform 980) tracks the program voltage (waveform 930).

At t0, the drain and source select gates are kept closed for the inhibited NAND strings. At t1, boosting of the source side channel is initiated by applying V_{LOW} (waveform 940), V_{ISO} (waveform 950) and V_{PASS} (waveform 960). Note the corresponding increase in V_{CH-SOURCE} (waveform 970). Between t1 and t2, boosting of the source side channel continues. After a delay, at t2, boosting of the drain side channel is initiated by applying V_{PASS} (waveform 920). Note the corresponding increase in V_{CH-DRAIN} (waveform 980). Boosting of the source and drain side channels continues until t6. At t3, the programming voltage V_{PGMI} is applied and, at t4, the programming voltage V_{PGM2} is applied. Thus, the program voltage can be applied initially at a first level and subsequently at a higher second level. This approach avoids abrupt changes in V_{CH-DRAIN} which may be caused by abrupt changes in V_{PGM}. However, a single stepped V_{PGM} pulse may alternatively be used. At t6, the boosting voltages are removed and, at t7, the boosting and programming cycle ends. The program voltage V_{PGM2} is removed at t5, just prior to the removal of the boosting voltages at t6.

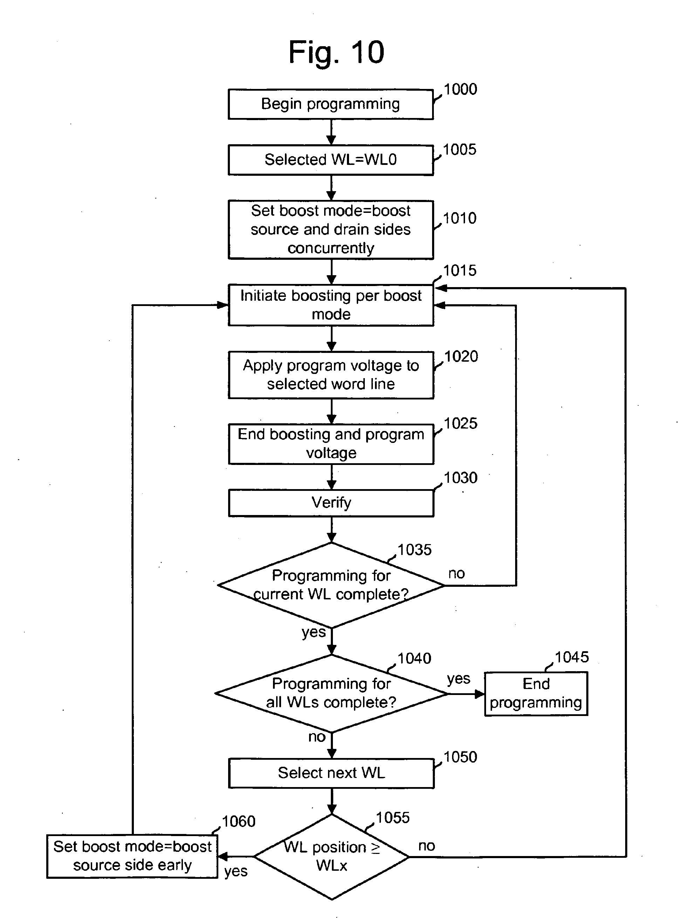

FIG. 10 depicts a process for switching a boost mode during programming based on a selected word line position. In one example approach, the boost mode is switched from a mode in which boosting of the source and drain side channels is initiated substantially concurrently to a mode in which the source side boosting is initiated early relative to the drain side boosting. In other words, the different boost modes involve a change in timing between initiation of the source side boosting and drain side boosting.

At step 1000, programming begins. At step 1005, a variable in memory which tracks the selected word line position is initialized to WL0. At step 1010, a variable in memory which identifies the current boost mode is set to indicate that the source and drain sides are to be boosted concurrently. At step 1015, boosting of the source and drain sides is initiated based on the current boost mode. At step 1020, a program voltage is applied to the currently selected word line (e.g., WL0). At step 1025, the boosting and program voltage end. At step 1030, a verify process is performed to determine if the storage elements which are being programmed have a reached a desired programming state. At decision step 1035, a determination is made as to whether the verify process indicates that programming is complete for the current word line. If programming for the current word line is not complete, the control flow continues at step 1015 with another boost and program cycle until programming for the current word line is complete. When programming for the current word line is complete, a determination is made at decision step 1040 as to whether programming is complete for all word lines. If programming is complete for all word lines, the programming ends at step 1045. If programming is not complete for all word lines, the next word line is selected for programming at step 1050.

A determination is made at decision step 1055 as to whether the current word line position is at or above a specified word line position (WLx). For example, WLx can be WL24 for a 32-word line NAND memory device. If the current word line position is not at or above the specified word line position, the control flow continues at step 1015 with another boost and program cycle. If the current word line position is at or above the specified word line position, the boost mode is set to indicate that the source side is to be boosted early relative to the drain side at step 1060, and the control flow continues at step 1015 with another boost and program cycle.

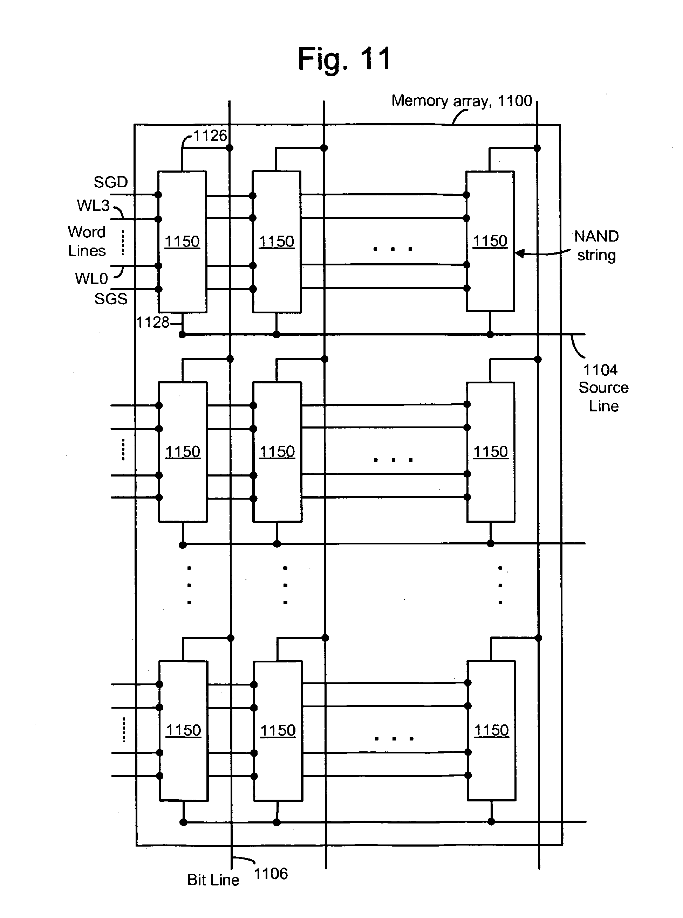

FIG. 11 illustrates an example of an array 1100 of NAND storage elements, such as those shown in FIGs. 1 and 2. Along each column, a bit line 1106 is coupled to the drain terminal 1126 of the drain select gate for the NAND string 1150. Along each row of NAND strings, a source line 1104 may connect all the source terminals 1128 of the source select gates of the NAND strings. An example of a NAND architecture array and its operation as part of a memory system is found in U.S. Patents Nos. 5,570,315; 5,774,397; and 6,046,935.

The array of storage elements is divided into a large number of blocks of storage elements. As is common for flash EEPROM systems, the block is the unit of erase. That is, each block contains the minimum number of storage elements that are erased together. Each block is typically divided into a number of pages. A page is a unit of programming. In one embodiment, the individual pages may be divided into segments and the segments may contain the fewest number of storage elements that are written at one time as a basic programming operation. One or more pages of data are typically stored in one row of storage elements. A page can store one or more sectors. A sector includes user data and overhead data. Overhead data typically includes an Error Correction Code (ECC) that has been calculated from the user data of the sector. A portion of the controller (described below) calculates the ECC when data is being programmed into the array, and also checks it when data is being read from the array. Alternatively, the ECCs and/or other overhead data are stored in different pages, or even different blocks, than the user data to which they pertain.

A sector of user data is typically 512 bytes, corresponding to the size of a sector in magnetic disk drives. Overhead data is typically an additional 16-20 bytes. A large number of pages form a block, anywhere from 8 pages, for example, up to 32, 64, 128 or more pages. In some embodiments, a row of NAND strings comprises a block.

Memory storage elements are erased in one embodiment by raising the p-well to an erase voltage (e.g., 20 V) for a sufficient period of time and grounding the word lines of a selected block while the source and bit lines are floating. Due to capacitive coupling, the unselected word lines, bit lines, select lines, and c-source are also raised to a significant fraction of the erase voltage. A strong electric field is thus applied to the tunnel oxide layers of selected storage elements and the data of the selected storage elements are erased as electrons of the floating gates are emitted to the substrate side, typically by Fowler-Nordheim tunneling mechanism. As electrons are transferred from the floating gate to the p-well region, the threshold voltage of a selected storage element is lowered. Erasing can be performed on the entire memory array, separate blocks, or another unit of storage elements.

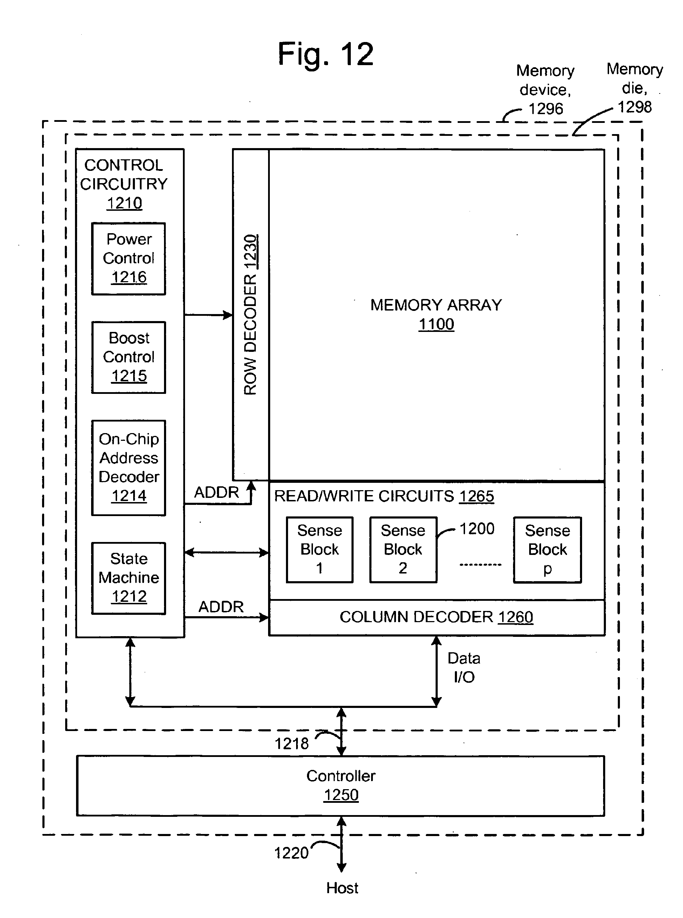

FIG. 12 is a block diagram of a non-volatile memory system using single row/column decoders and read/write circuits. The diagram illustrates a memory device 1296 having read/write circuits for reading and programming a page of storage elements in parallel, according to one embodiment of the present invention. Memory device 1296 may include one or more memory die 1298. Memory die 1298 includes a two-dimensional array of storage elements 1100, control circuitry 1210, and read/write circuits 1265. In some embodiments, the array of storage elements can be three dimensional. The memory array 1100 is addressable by word lines via a row decoder 1230 and by bit lines via a column decoder 1260. The read/write circuits 1265 include multiple sense blocks 1200 and allow a page of storage elements to be read or programmed in parallel. Typically a controller 1250 is included in the same memory device 1296 (e.g., a removable storage card) as the one or more memory die 1298. Commands and Data are transferred between the host and controller 1250 via lines 1220 and between the controller and the one or more memory die 1298 via lines 1218.

The control circuitry 1210 cooperates with the read/write circuits 1265 to perform memory operations on the memory array 1100. The control circuitry 1210 includes a state machine 1212, an on-chip address decoder 1214, a boost control 1215 and a power control module 1216. The state machine 1212 provides chip-level control of memory operations. The on-chip address decoder 1214 provides an address interface between that used by the host or a memory controller to the hardware address used by the decoders 1230 and 1260. The boost control 1215 can be used for setting a boost mode, including determining a timing for initiating source side and drain side boosting, as discussed herein. The power control module 1216 controls the power and voltages supplied to the word lines and bit lines during memory operations.

In some implementations, some of the components of FIG. 12 can be combined. In various designs, one or more of the components (alone or in combination), other than storage element array 1100, can be thought of as a managing circuit. For example, one or more managing circuits may include any one of or a combination of control circuitry 1210, state machine 1212, decoders 1214/1260, power control 1216, sense blocks 1200, read/write circuits 1265, controller 1250, etc.

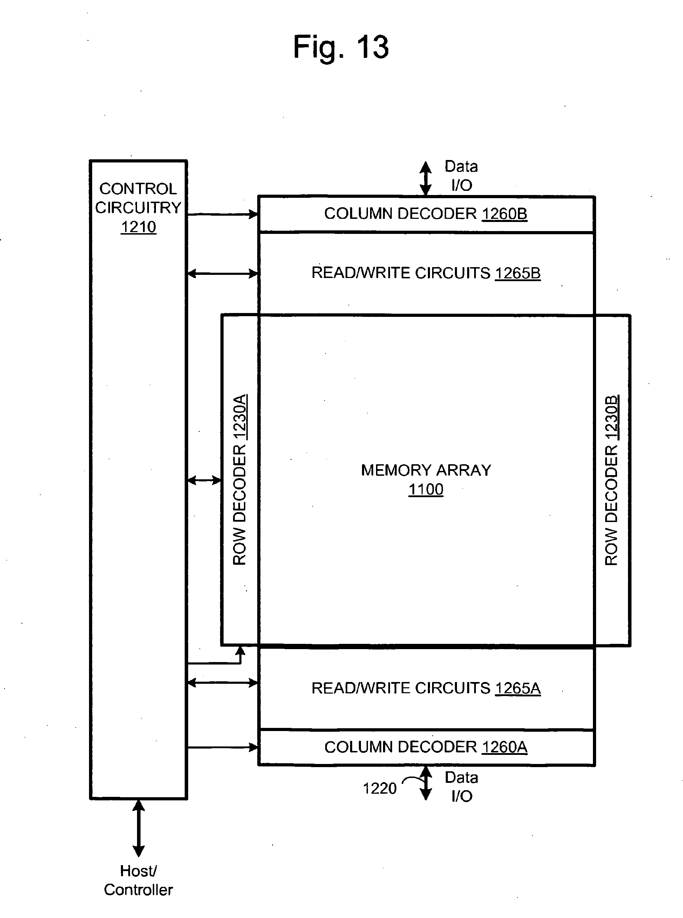

FIG. 13 is a block diagram of a non-volatile memory system using dual row/column decoders and read/write circuits. Here, another arrangement of the memory device 1296 shown in FIG. 12 is provided. Access to the memory array 1100 by the various peripheral circuits is implemented in a symmetric fashion, on opposite sides of the array, so that the densities of access lines and circuitry on each side are reduced by half. Thus, the row decoder is split into row decoders 1230A and 1230B and the column decoder into column decoders 1260A and 1260B. Similarly, the read/write circuits are split into read/write circuits 1265A connecting to bit lines from the bottom and read/write circuits 1265B connecting to bit lines from the top of the array 1100. In this way, the density of the read/write modules is essentially reduced by one half. The device of FIG. 13 can also include a controller, as described above for the device of FIG. 12.

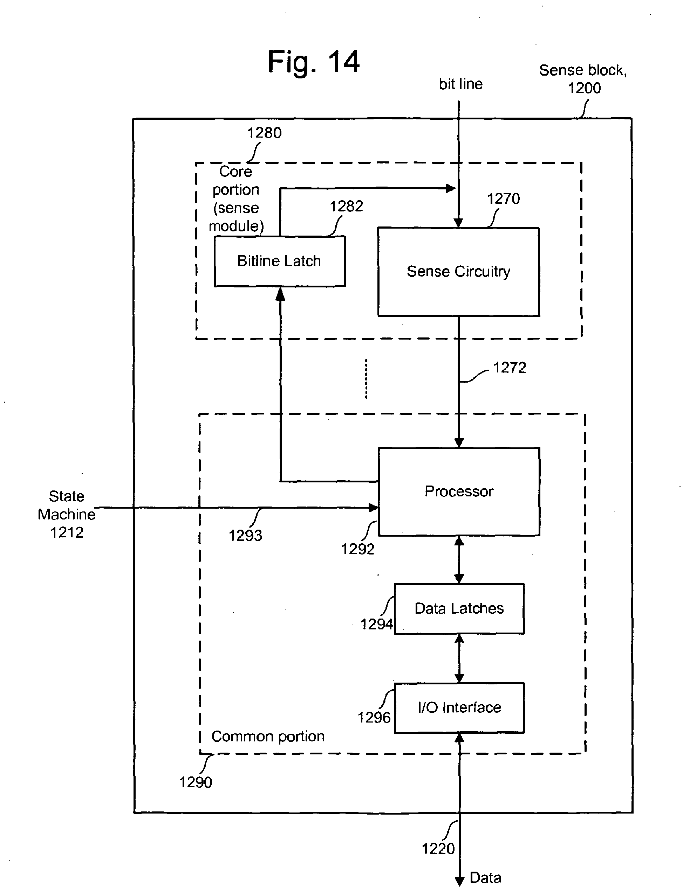

FIG. 14 is a block diagram depicting one embodiment of a sense block. An individual sense block 1200 is partitioned into a core portion, referred to as a sense module 1280, and a common portion 1290. In one embodiment, there will be a separate sense module 1280 for each bit line and one common portion 1290 for a set of multiple sense modules 1280. In one example, a sense block will include one common portion 1290 and eight sense modules 1280. Each of the sense modules in a group will communicate with the associated common portion via a data bus 1272. For further details refer to U.S. Patent Application Pub No. 2006/0140007, titled "Non-Volatile Memory and Method with Shared Processing for an Aggregate of Sense Amplifiers' published June 29, 2006.

Sense module 1280 comprises sense circuitry 1270 that determines whether a conduction current in a connected bit line is above or below a predetermined threshold level. Sense module 1280 also includes a bit line latch 1282 that is used to set a voltage condition on the connected bit line. For example, a predetermined state latched in bit line latch 1282 will result in the connected bit line being pulled to a state designating program inhibit (e.g., V_{dd}).

Common portion 1290 comprises a processor 1292, a set of data latches 1294 and an I/O Interface 1296 coupled between the set of data latches 1294 and data bus 1220. Processor 1292 performs computations. For example, one of its functions is to determine the data stored in the sensed storage element and store the determined data in the set of data latches. The set of data latches 1294 is used to store data bits determined by processor 1292 during a read operation. It is also used to store data bits imported from the data bus 1220 during a program operation. The imported data bits represent write data meant to be programmed into the memory. I/O interface 1296 provides an interface between data latches 1294 and the data bus 1220.

During read or sensing, the operation of the system is under the control of state machine 1212 that controls the supply of different control gate voltages to the addressed storage element. As it steps through the various predefined control gate voltages corresponding to the various memory states supported by the memory, the sense module 1280 may trip at one of these voltages and an output will be provided from sense module 1280 to processor 1292 via bus 1272. At that point, processor 1292 determines the resultant memory state by consideration of the tripping event(s) of the sense module and the information about the applied control gate voltage from the state machine via input lines 1293. It then computes a binary encoding for the memory state and stores the resultant data bits into data latches 1294. In another embodiment of the core portion, bit line latch 1282 serves double duty, both as a latch for latching the output of the sense module 1280 and also as a bit line latch as described above.

It is anticipated that some implementations will include multiple processors 1292. In one embodiment, each processor 1292 will include an output line (not depicted) such that each of the output lines is wired-OR'd together. In some embodiments, the output lines are inverted prior to being connected to the wired-OR line. This configuration enables a quick determination during the program verification process of when the programming process has completed because the state machine receiving the wired-OR can determine when all bits being programmed have reached the desired level. For example, when each bit has reached its desired level, a logic zero for that bit will be sent to the wired-OR line (or a data one is inverted). When all bits output a data 0 (or a data one inverted), then the state machine knows to terminate the programming process. Because each processor communicates with eight sense modules, the state machine needs to read the wired-OR line eight times, or logic is added to processor 1292 to accumulate the results of the associated bit lines such that the state machine need only read the wired-OR line one time. Similarly, by choosing the logic levels correctly, the global state machine can detect when the first bit changes its state and change the algorithms accordingly.

During program or verify, the data to be programmed is stored in the set of data latches 1294 from the data bus 1220. The program operation, under the control of the state machine, comprises a series of programming voltage pulses applied to the control gates of the addressed storage elements. Each programming pulse is followed by a read back (verify) to determine if the storage element has been programmed to the desired memory state. Processor 1292 monitors the read back memory state relative to the desired memory state. When the two are in agreement, the processor 1292 sets the bit line latch 1282 so as to cause the bit line to be pulled to a state designating program inhibit. This inhibits the storage element coupled to the bit line from further programming even if programming pulses appear on its control gate. In other embodiments the processor initially loads the bit line latch 1282 and the sense circuitry sets it to an inhibit value during the verify process.

Data latch stack 1294 contains a stack of data latches corresponding to the sense module. In one embodiment, there are three data latches per sense module 1280. In some implementations (but not required), the data latches are implemented as a shift register so that the parallel data stored therein is converted to serial data for data bus 1220, and vice versa. In the preferred embodiment, all the data latches corresponding to the read/write block of m storage elements can be linked together to form a block shift register so that a block of data can be input or output by serial transfer. In particular, the bank of r read/write modules is adapted so that each of its set of data latches will shift data in to or out of the data bus in sequence as if they are part of a shift register for the entire read/write block.

Additional information about the structure and/or operations of various embodiments of non-volatile storage devices can be found in (1) U.S. Patent Application Pub. No. 2004/0057287, "Non-Volatile Memory And Method With Reduced Source Line Bias Errors," published on March 25, 2004; (2) U.S. Patent Application Pub No. 2004/0109357, "Non-Volatile Memory And Method with Improved Sensing," published on June 10, 2004; (3) U.S. Patent Application No. 11/015,199 titled "Improved Memory Sensing Circuit And Method For Low Voltage Operation," filed on December 16, 2004 (US. Publication No. 2005/0169082; (4) U.S. Patent Application 11/099,133, titled "Compensating for Coupling During Read Operations of Non-Volatile Memory," filed on April 5, 2005 (US Publication No. 2004/0221692); and (5) U.S. Patent Application No. 11/321,953, tilled "Reference Sense Amplifier For Non-Volatile Memory, filed on December 28, 2005 (US Publication No. 2004/0156947.

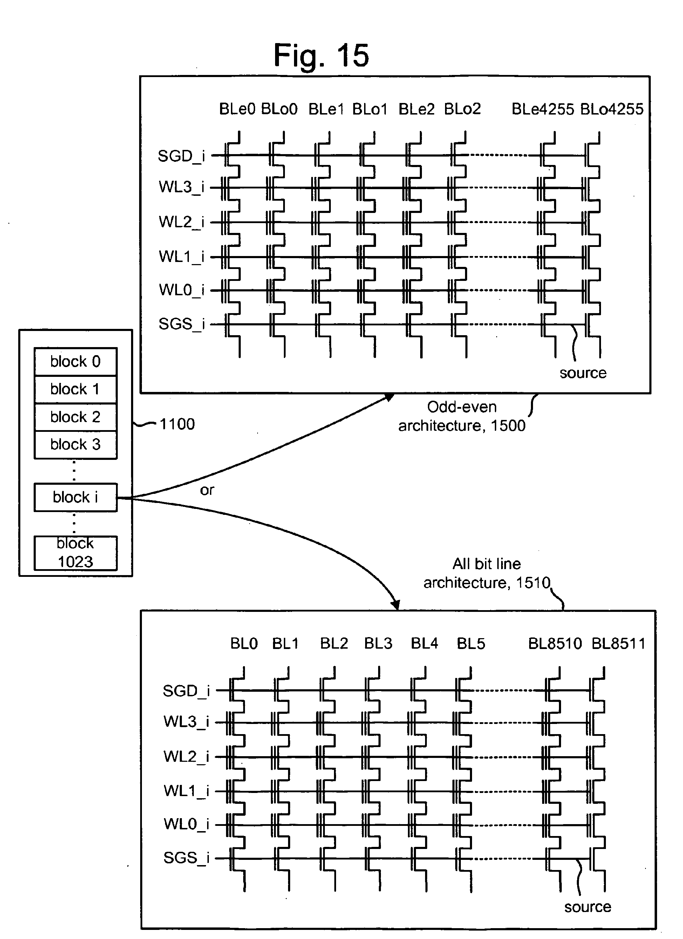

FIG. 15 illustrates an example of an organization of a memory array into blocks for an all bit line memory architecture or for an odd-even memory architecture. Exemplary structures of memory array 1100 are described. As one example, a NAND flash EEPROM is described that is partitioned into 1,024 blocks. The data stored in each block can be simultaneously erased. In one embodiment, the block is the minimum unit of storage elements that are simultaneously erased. In each block, in this example, there are 8,512 columns corresponding to bit lines BL0, BL1, ... BL8511. In one embodiment referred to as an all bit line (ABL) architecture (architecture 1510), all the bit lines of a block can be simultaneously selected during read and program operations. Storage elements along a common word line and connected to any bit line can be programmed at the same time.

In the example provided, four storage elements are connected in series to form a NAND string. Although four storage elements are shown to be included in each NAND string, more or less than four can be used (e.g., 16, 32, 64 or another number). One terminal of the NAND string is connected to a corresponding bit line via a drain select gate (connected to select gate drain lines SGD), and another terminal is connected to c-source via a source select gate (connected to select gate source line SGS).

In another embodiment, referred to as an odd-even architecture (architecture 1500), the bit lines are divided into even bit lines (BLe) and odd bit lines (BLo). In the odd/even bit line architecture, storage elements along a common word line and connected to the odd bit lines are programmed at one time, while storage elements along a common word line and connected to even bit lines are programmed at another time. Data can be programmed into different blocks and read from different blocks concurrently. In each block, in this example, there are 8,512 columns that are divided into even columns and odd columns. In this example, four storage elements are shown connected in series to form a NAND string. Although four storage elements are shown to be included in each NAND string, more or fewer than four storage elements can be used.

During one configuration of read and programming operations, 4,256 storage elements are simultaneously selected. The storage elements selected have the same word line and the same kind of bit line (e.g., even or odd). Therefore, 532 bytes of data, which form a logical page, can be read or programmed simultaneously, and one block of the memory can store at least eight logical pages (four word lines, each with odd and even pages). For multi-state storage elements, when each storage element stores two bits of data, where each of these two bits are stored in a different page, one block stores sixteen logical pages. Other sized blocks and pages can also be used.

For either the ABL or the odd-even architecture, storage elements can be erased by raising the p-well to an erase voltage (e.g., 20 V) and grounding the word lines of a selected block. The source and bit lines are floating. Erasing can be performed on the entire memory array, separate blocks, or another unit of the storage elements which is a portion of the memory device. Electrons are transferred from the floating gates of the storage elements to the p-well region so that the V_{TH} of the storage elements becomes negative.

In the read and verify operations, the select gates (SGD and SGS) are connected to a voltage in a range of 2.5 to 4.5 V and the unselected word lines (e.g., WL0, WL1 and WL3, when WL2 is the selected word line) are raised to a read pass voltage, V_{READ}, (typically a voltage in the range of 4.5 to 6 V) to make the transistors operate as pass gates. The selected word line WL2 is connected to a voltage, a level of which is specified for each read and verify operation in order to determine whether a V_{TH} of the concerned storage element is above or below such level. For example, in a read operation for a two-level storage element, the selected word line WL2 may be grounded, so that it is detected whether the V_{TH} is higher than 0 V. In a verify operation for a two level storage element, the selected word line WL2 is connected to 0.8 V, for example, so that it is verified whether or not the V_{TH} has reached at least 0.8 V. The source and p-well are at 0 V. The selected bit lines, assumed to be the even bit lines (BLe), are pre-charged to a level of, for example, 0.7 V. If the V_{TH} is higher than the read or verify level on the word line, the potential level of the bit line (BLe) associated with the storage element of interest maintains the high level because of the non-conductive storage element. On the other hand, if the V_{TH} is lower than the read or verify level, the potential level of the concerned bit line (BLe) decreases to a low level, for example, less than 0.5 V, because the conductive storage element discharges the bit line. The state of the storage element can thereby be detected by a voltage comparator sense amplifier that is connected to the bit line.

The erase, read and verify operations described above are performed according to techniques known in the art. Thus, many of the details explained can be varied by one skilled in the art. Other erase, read and verify techniques known in the art can also be used.

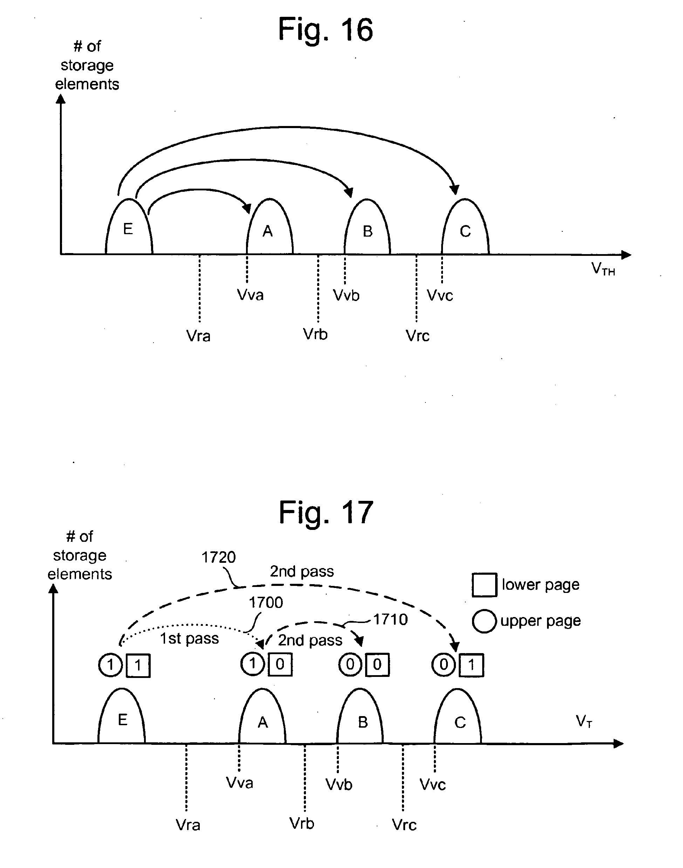

FIG. 16 depicts an example set of threshold voltage distributions. Example V_{TH} distributions for the storage element array are provided for a case where each storage element stores two bits of data. A first threshold voltage distribution E is provided for erased storage elements. Three threshold voltage distributions, A, B and C for programmed storage elements, are also depicted. In one embodiment, the threshold voltages in the E distribution are negative and the threshold voltages in the A, B and C distributions are positive.

Each distinct threshold voltage range corresponds to predetermined values for the set of data bits. The specific relationship between the data programmed into the storage element and the threshold voltage levels of the storage element depends upon the data encoding scheme adopted for the storage elements. For example, U.S. Patent No. 6,222,762 and U.S. Patent Application Publication No. 2004/0255090, published December 16, 2004 describe various data encoding schemes for multi-state flash storage elements. In one embodiment, data values are assigned to the threshold voltage ranges using a Gray code assignment so that if the threshold voltage of a floating gate erroneously shifts to its neighboring physical state, only one bit will be affected. One example assigns "11" to threshold voltage range E (state E), "10" to threshold voltage range A (state A), "00" to threshold voltage range B (state B) and "01" to threshold voltage range C (state C). However, in other embodiments, Gray code is not used. Although four states are shown, the present invention can also be used with other multi-state structures including those that include more or less than four states.

Three read reference voltages, Vra, Vrb and Vrc, are also provided for reading data from storage elements. By testing whether the threshold voltage of a given storage element is above or below Vra, Vrb and Vrc, the system can determine the state, e.g., programming condition, the storage element is in.

Further, three verify reference voltages, Vva, Vvb and Vvc, are provided. When programming storage elements to state A, the system will test whether those storage elements have a threshold voltage greater than or equal to Vva. When programming storage elements to state B, the system will test whether the storage elements have threshold voltages greater than or equal to Vvb. When programming storage elements to state C, the system will determine whether storage elements have their threshold voltage greater than or equal to Vvc.

In one embodiment, known as full sequence programming, storage elements can be programmed from the erase state E directly to any of the programmed states A, B or C. For example, a population of storage elements to be programmed may first be erased so that all storage elements in the population are in erased state E. A series of programming pulses such as depicted by the control gate voltage sequence of FIG. 20 will then be used to program storage elements directly into states A, B or C. While some storage elements are being programmed from state E to state A, other storage elements are being programmed from state E to state B and/or from state E to state C. When programming from state E to state C on WLn, the amount of parasitic coupling to the adjacent floating gate under WLn-1 is a maximized since the change in amount of charge on the floating gate under WLn is largest as compared to the change in voltage when programming from state E to state A or state E to state B. When programming from state E to state B the amount of coupling to the adjacent floating gate is reduced but still significant. When programming from state E to state A the amount of coupling is reduced even further. Consequently the amount of correction required to subsequently read each state of WLn-1 will vary depending on the state of the adjacent storage element on WLn.

FIG. 17 illustrates an example of a two-pass technique of programming a multi-state storage element that stores data for two different pages: a lower page and an upper page. Four states are depicted: state E (11), state A (10), state B (00) and state C (01). For state E, both pages store a "1." For state A, the lower page stores a "0" and the upper page stores a "1." For state B, both pages store "0." For state C, the lower page stores "1" and the upper page stores "0." Note that although specific bit patterns have been assigned to each of the states, different bit patterns may also be assigned.

In a first programming pass, the storage element's threshold voltage level is set according to the bit to be programmed into the lower logical page. If that bit is a logic "1," the threshold voltage is not changed since it is in the appropriate state as a result of having been earlier erased. However, if the bit to be programmed is a logic "0," the threshold level of the storage element is increased to be state A, as shown by arrow 1100. That concludes the first programming pass.

In a second programming pass, the storage element's threshold voltage level is set according to the bit being programmed into the upper logical page. If the upper logical page bit is to store a logic "1," then no programming occurs since the storage element is in one of the states E or A, depending upon the programming of the lower page bit, both of which carry an upper page bit of "1." If the upper page bit is to be a logic "0," then the threshold voltage is shifted. If the first pass resulted in the storage element remaining in the erased state E, then in the second phase the storage element is programmed so that the threshold voltage is increased to be within state C, as depicted by arrow 1720. If the storage element had been programmed into state A as a result of the first programming pass, then the storage element is further programmed in the second pass so that the threshold voltage is increased to be within state B, as depicted by arrow 1710. The result of the second pass is to program the storage element into the state designated to store a logic "0" for the upper page without changing the data for the lower page. In both FIG. 16 and FIG. 17, the amount of coupling to the floating gate on the adjacent word line depends on the final state.

In one embodiment, a system can be set up to perform full sequence writing if enough data is written to fill up an entire page. If not enough data is written for a full page, then the programming process can program the lower page programming with the data received. When subsequent data is received, the system will then program the upper page. In yet another embodiment, the system can start writing in the mode that programs the lower page and convert to full sequence programming mode if enough data is subsequently received to fill up an entire (or most of a) word line's storage elements. More details of such an embodiment are disclosed in U.S. Patent Application Pub. No. 2006/0126390, titled "Pipelined Programming of Non-Volatile Memories Using Early Data," published June 15, 2006.

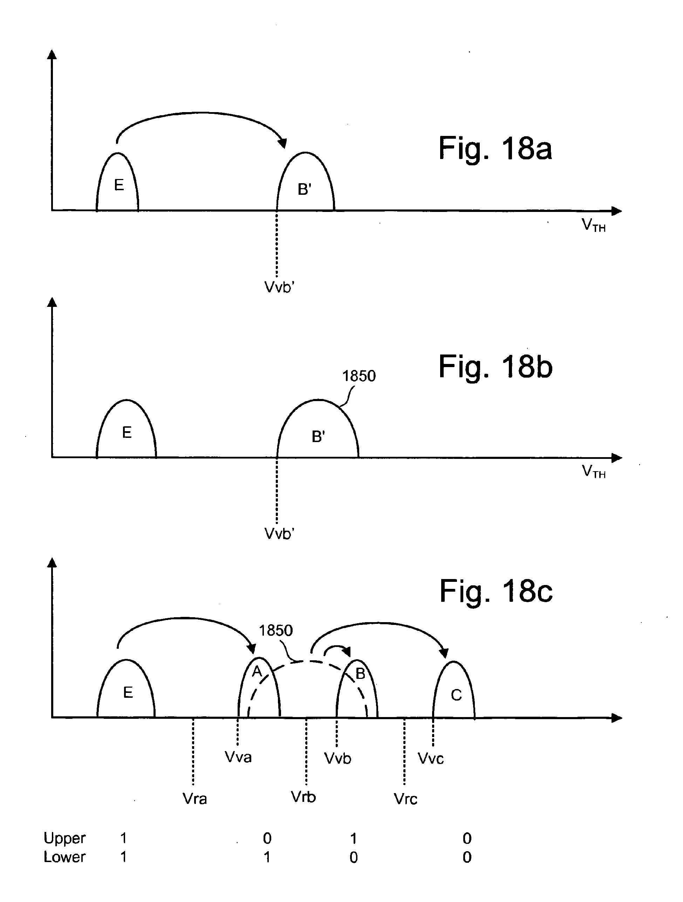

FIGs. 18a-c disclose another process for programming non-volatile memory that reduces the effect of floating gate to floating gate coupling by, for any particular storage element, writing to that particular storage element with respect to a particular page subsequent to writing to adjacent storage elements for previous pages. In one example implementation, the non-volatile storage elements store two bits of data per storage element, using four data states. For example, assume that state E is the erased state and states A, B and C are the programmed states. State E stores data 11. State A stores data 01, State B stores data 10. State C stores data 00. This is an example of non-Gray coding because both bits change between adjacent states A and B. Other encodings of data to physical data states can also be used. Each storage element stores two pages of data. For reference purposes, these pages of data will be called upper page and lower page; however, they can be given other labels. With reference to state A, the upper page stores bit 0 and the lower page stores bit 1. With reference to state B, the upper page stores bit 1 and the lower page stores bit 0. With reference to state C, both pages store bit data 0.

The programming process is a two-step process. In the first step, the lower page is programmed. If the lower page is to remain data 1, then the storage element state remains at state E. If the data is to be programmed to 0, then the threshold of voltage of the storage element is raised such that the storage element is programmed to state B'. FIG. 18a therefore shows the programming of storage elements from state E to state B'. State B' is an interim state B; therefore, the verify point is depicted as Vvb', which is lower than Vvb.

In one embodiment, after a storage element is programmed from state E to state B', its neighbor storage element (WLn+1) in the NAND string will then be programmed with respect to its lower page. For example, looking back at FIG. 2, after the lower page for storage element 106 is programmed, the lower page for storage element 104 would be programmed. After programming storage element 104, the floating gate to floating gate coupling effect will raise the apparent threshold voltage of storage element 106 if storage element 104 had a threshold voltage raised from state E to state B'. This will have the effect of widening the threshold voltage distribution for state B' to that depicted as threshold voltage distribution 1850 of FIG. 18b. This apparent widening of the threshold voltage distribution will be remedied when programming the upper page.

FIG. 18c depicts the process of programming the upper page. If the storage element is in erased state E and the upper page is to remain at 1, then the storage element will remain in state E. If the storage element is in state E and its upper page data is to be programmed to 0, then the threshold voltage of the storage element will be raised so that the storage element is in state A. If the storage element was in intermediate threshold voltage distribution 1850 and the upper page data is to remain at 1, then the storage element will be programmed to final state B. If the storage element is in intermediate threshold voltage distribution 1850 and the upper page data is to become data 0, then the threshold voltage of the storage element will be raised so that the storage element is in state C. The process depicted by FIGs. 18a-c reduces the effect of floating gate to floating gate coupling because only the upper page programming of neighbor storage elements will have an effect on the apparent threshold voltage of a given storage element. An example of an alternate state coding is to move from distribution 1850 to state C when the upper page data is a 1, and to move to state B when the upper page data is a 0.

Although FIGs. 18a-c provide an example with respect to four data states and two pages of data, the concepts taught can be applied to other implementations with more or fewer than four states and different than two pages.

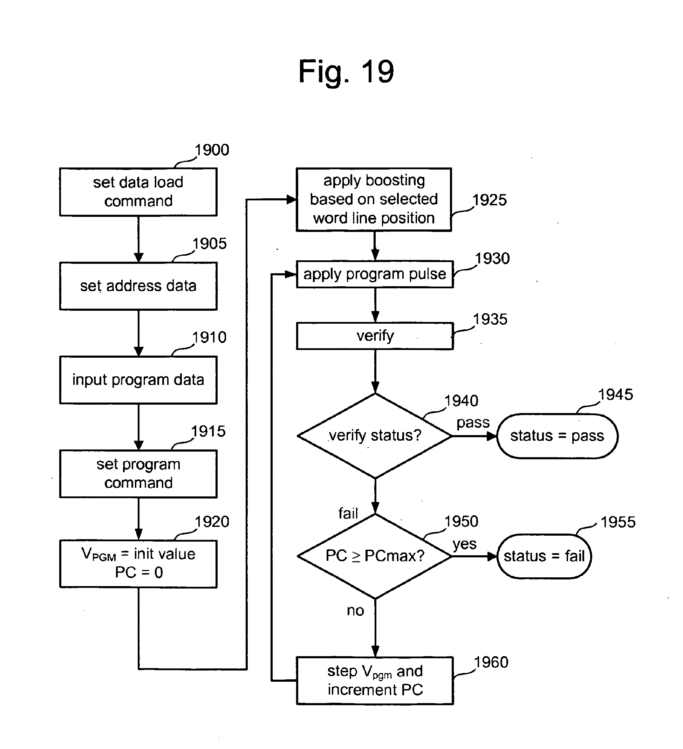

FIG. 19 is a flow chart describing one embodiment of a method for programming non-volatile memory. In one implementation, storage elements are erased (in blocks or other units) prior to programming. In step 1900, a "data load" command is issued by the controller and input received by control circuitry 1210. In step 1905, address data designating the page address is input to decoder 1214 from the controller or host. In step 1910, a page of program data for the addressed page is input to a data buffer for programming. That data is latched in the appropriate set of latches. In step 1915, a "program" command is issued by the controller to state machine 1212.

Triggered by the "program" command, the data latched in step 1910 will be programmed into the selected storage elements controlled by state machine 1212 using the stepped program pulses of the pulse train 2000 of FIG. 20 applied to the appropriate selected word line. In step 1920, the program voltage, V_{PGM}, is initialized to the starting pulse (e.g., 12 V or other value) and a program counter (PC) maintained by state machine 1212 is initialized at zero. In step 1925, boosting is applied based a currently set boost mode (e.g., boost source and drain sides concurrently or boost source side early). The current boost mode can be a function of the currently selected word line position, for instance, as discussed. In another approach, the boost mode is fixed or otherwise independent of the word line position. For instance, the source side can be boosted early for all selected word line positions.

In step 1930, the first V_{PGM} pulse is applied to the selected word line to begin programming storage elements associated with the selected word line. If logic "0" is stored in a particular data latch indicating that the corresponding storage element should be programmed, then the corresponding bit line is grounded. On the other hand, if logic "1" is stored in the particular latch indicating that the corresponding storage element should remain in its current data state, then the corresponding bit line is connected to V_{dd} to inhibit programming.

In step 1935, the states of the selected storage elements are verified. If it is detected that the target threshold voltage of a selected storage element has reached the appropriate level, then the data stored in the corresponding data latch is changed to a logic "1." If it is detected that the threshold voltage has not reached the appropriate level, the data stored in the corresponding data latch is not changed. In this manner, a bit line having a logic "1" stored in its corresponding data latch does not need to be programmed. When all of the data latches are storing logic "1," the state machine (via the wired-OR type mechanism described above) knows that all selected storage elements have been programmed. In step 1940, a check is made as to whether all of the data latches are storing logic "1." If all of the data latches are storing logic "1," the programming process is complete and successful because all selected storage elements were programmed and verified. A status of "PASS" is reported in step 1945.

If, in step 1940, it is determined that not all of the data latches are storing logic "1," then the programming process continues. In step 1950, the program counter PC is checked against a program limit value PCmax. One example of a program limit value is twenty; however, other numbers can also be used. If the program counter PC is not less than PCmax, then the program process has failed and a status of "FAIL" is reported in step 1955. If the program counter PC is less than PCmax, then V_{PGM} is increased by the step size and the program counter PC is incremented in step 1960. The process then loops back to step 1930 to apply the next V_{PGM} pulse.

FIG. 20 depicts an example pulse train 2000 applied to the control gates of non-volatile storage elements during programming, and a switch in boost mode which occurs during a pulse train. The pulse train 2000 includes a series of program pulses 2005, 2010, 2015, 2020, 2025, 2030, 2035, 2040, 2045, 2050, ..., that are applied to a word line selected for programming. In one embodiment, the programming pulses have a voltage, V_{PGM}, which starts at 12 V and increases by increments, e.g., 0.5 V, for each successive programming pulse until a maximum of 20 V is reached. In between the program pulses are verify pulses. For example, verify pulse set 2006 includes three verify pulses. In some embodiments, there can be a verify pulse for each state that data is being programmed into, e.g., state A, B and C. In other embodiments, there can be more or fewer verify pulses The verify pulses in each set can have amplitudes of Vva, Vvb and Vvc (FIG. 17) or Vvb' (FIG. 18a), for instance.

As mentioned, the voltages which are applied to word lines to implement a boost mode are applied when programming occurs, e.g., prior to and during a program pulse. In practice, the boost voltages of a boost mode can be initiated slightly before each program pulse and removed after each program pulse. On the other hand, during the verify process, for instance, which occurs between program pulses, the boost voltages are not applied. Instead, read voltages, which are typically less than the boost voltages, are applied to the unselected word lines. The read voltages have an amplitude which is sufficient to maintain the previously programmed storage elements in a NAND string on when the threshold voltage of a currently-programmed storage element is being compared to a verify level.

The foregoing detailed description of the invention has been presented for purposes of illustration and description. It is not intended to be exhaustive or to limit the invention to the precise form disclosed. Many modifications and variations are possible in light of the above teaching. The described embodiments were chosen in order to best explain the principles of the invention and its practical application, to thereby enable others skilled in the art to best utilize the invention in various embodiments and with various modifications as are suited to the particular use contemplated. It is intended that the scope of the invention be defined by the claims appended hereto.

## Claims

1. A method for programming non-volatile storage having a NAND flash memory structure, comprising;
boosting a first region of a substrate (490), a set of non-volatile storage elements (406,408,...,422) is formed, at least in part, on the substrate, the set of non-volatile storage elements is associated with a set of word lines (WL0,WL2,...,WL7) and includes at least one non-volatile storage element (418) associated with a selected word line (WL5) of the set of word lines, the first region is on a source side of said associated with the selected word line (WL5) element;
boosting a second region of the substrate on a drain side of said associated with the selected word line (WL5) element;
and
during the boosting of the first and second regions, applying an isolation voltage to at least one word line (WL2) in the set of word lines on the source side of said associated with the selected word line (WL5) element;
**characterised in that**:
the boosting of the first region occurring early relative to the boosting of the second region.

2. The method of claim 1, wherein:
the boosting of the first region comprises applying a pass voltage to at least one word line (WL0,WL1) in the set of word lines on the source side of the selected word line, and the boosting of the second region comprises applying a pass voltage to at least one other word line (WL6,WL7) in the set of word lines on the drain side of the selected word line.

3. The method of claim 1 or 2, wherein:
the set of non-volatile storage elements (406,408,...,422) is provided in at least one NAND string which extends between a source side select gate (406) and a drain side select gate (424);
the method further comprising:
maintaining the source side select gate (406) and the drain side select gate (424) closed during the boosting of the first and second regions.

4. The method of any preceding claim, further comprising:
applying a program voltage to the at least one non-volatile storage element (418) via the selected word line (WL5) during at least part of a time period involving the boosting of the first and second regions;
wherein the boosting of the second region of the substrate (490) continues during the applying of the program voltage on the selected word line (WL5).

5. The method of any preceding claim, wherein the boosting of the first and second regions is performed in connection with programming of the at least one non-volatile storage element (418) via the selected word line (WL5), and the selected word line is among a predetermined group of word lines of the set of word lines which is adjacent to a drain side of the set of non-volatile storage elements, the method further comprising:
concurrently initiating boosting of source and drain side regions of a subsequently selected word line in connection with programming of at least one additional non-volatile storage element via the subsequently selected word line, the subsequently selected word line is not among the predetermined group of word lines.

6. The method of claim 5, wherein
the predetermined group of word lines comprises approximately 25% of the word lines of the set of word lines.

7. A non-volatile storage system having a NAND flash memory structure, comprising;
a set of non-volatile storage elements (406,408,...,422;1000) formed, at least in part, on a substrate (490);
a set of word lines (WL0,WL1,...,WL7) associated with the set of non-volatile storage elements, including a selected word line (WL5) which is associated with at least one non-volatile storage element (418) of the set of non-volatile storage elements; and
one or more control circuits (1250) in communication with the set of non-volatile storage elements (1100);
wherein the one or more control circuits are arranged to boost a first region of the substrate (490) on a source side of said associated with the selected word line (WL5) element,
boost a second region of the substrate (490) on a drain side or said associated with the selected word line (WL5) element,
and, during the boosting of the first and second regions, apply an isolation voltage to at least one word line (WL2) in the set of word lines on the source side of said associated with the selected word line (WL5) element;
**characterise in that**:
the one or more control circuits (1250) are arranged to initiate boosting of the first region early relative to the boosting of the second region.

8. The non-volatile storage system of claim 7, wherein;
the one or more control circuits (1250) are arranged to boost the first region by applying a pass voltage to at least one word line (WL0,WL1) in the set of word lines on the source side of the selected word line, and to boost the second region by applying a pass voltage to at least one other word line (WL6,WL7) in the set of word lines on the drain side of the selected word line.

9. The non-volatile storage system of claim 7 or 8, wherein:
the set of non-volatile storage elements (406,408,...,422;1000) is provided in at least one NAND string which extends between a source side select gate (406) and a drain side select gate (424); and
the one or more control circuits (1250) are arranged to maintain the source side select gate (406) and the drain side select gate (424) closed during the boosting of the first and second regions.

10. The non-volatile storage system of any one of claims 7 to 9, wherein:
the one or more control circuits (1250) are arranged to apply a programming voltage to the at least one non-volatile storage element (418) via the selected word line (WL5) during at least part of a time period involving the boosting of the first and second regions; and
the one or more control circuits (1250) are further arranged to continue the boosting of the second region of the substrate (490) during the applying of the programming voltage on the selected word line (WL5).

11. The non-volatile storage system of any one of claims 7 to 10, wherein:
the one or more control circuits (1250) are arranged to perform the boosting of the first and second regions in connection with programming of the at least one non-volatile storage element (418) via the selected word line (WL25), the selected word line being among a predetermined group of word lines of the set of word lines which is adj acent to a drain side of the set of non-volatile storage elements; and
the one or more control circuits are further arranged to concurrently initiate boosting of source and drain side regions of a subsequently selected word line in connection with programming of at least one additional non-volatile storage element via the subsequently selected word line, the subsequently selected word line is not among the predetermined group of word lines.

12. The non-volatile storage system of claim 11, wherein:
the predetermined group of word lines comprises approximately 25% of the word lines of the set of word lines.

## Patentansprüche

1. Speicher zum Programmieren von nichtflüchtigem Speicher, der eine NAND-Flash-Speicherstruktur hat, das umfasst:
Erhöhen der Spannung bzw. Boosten eines ersten Bereiches eines Substrats (490), wobei wenigstens teilweise auf dem Substrat eine Menge nichtflüchtiger Speicherelemente (406, 408, ..., 422) gebildet ist, wobei die Menge nichtflüchtiger Speicherelemente einer Menge von Wortleitungen (WL0, WL2, ..., WL7) zugeordnet ist und wenigstens ein nichtflüchtiges Speicherelement (418) enthält, das einer ausgewählten Wortleitung (WL5) der Menge von Wortleitungen zugeordnet ist, wobei sich der erste Bereich auf einer Source-Seite des wenigstens einen nichtflüchtigen Speicherelements befindet, das der ausgewählten Wortleitung (WL5) zugeordnet ist;
Erhöhen der Spannung eines zweiten Bereichs des Substrats auf einer Drain-Seite des wenigstens einen nichtflüchtigen Speicherelements, das der ausgewählten Wortleitung (WL5) zugeordnet ist; und
während des Erhöhens der Spannung des ersten und des zweiten Bereichs Anlegen einer Isolierspannung an wenigstens eine Wortleitung (WL2) der Menge von Wortleitungen auf der Source-Seite des wenigstens einen nichtflüchtigen Speicherelements, das der ausgewählten Wortleitung (WL5) zugeordnet ist;
**dadurch gekennzeichnet, dass**:
das Erhöhen der Spannung des ersten Bereichs in Bezug auf das Erhöhen der Spannung des zweiten Bereichs früher erfolgt.

2. Verfahren nach Anspruch 1, wobei:
das Erhöhen der Spannung des ersten Bereichs das Anlegen einer Durchlassspannung an wenigstens eine Wortleitung (WL0, Wl1) in der Menge von Wortleitungen auf der Source-Seite der ausgewählten Wortleitung umfasst und das Erhöhen der Spannung des zweiten Bereichs das Anlegen einer Durchlassspannung an wenigstens eine andere Wortleitung (WL6, WL7) in der Menge von Wortleitungen auf der Drain-Seite der ausgewählten Wortleitung umfasst.

3. Verfahren nach Anspruch 1 oder 2, wobei:
die Menge nichtflüchtiger Speicherelemente (406, 408, ... 422) in wenigstens einer NAND-Kette vorgesehen ist, die sich zwischen einem Auswahl-Gate (406) auf Seiten der Source und einem Auswahl-Gate (424) auf Seiten des Drains befindet;
wobei das Verfahren ferner umfasst:
Geschlossenhalten des Auswahl-Gates (406) auf Seiten der Source und des Auswahl-Gates (424) auf Seiten des Drains während des Erhöhens der Spannungen des ersten und des zweiten Bereichs.

4. Verfahren nach einem vorhergehenden Anspruch, das ferner umfasst:
Anlegen einer Programmierspannung an das wenigstens eine nichtflüchtige Speicherelement (418) über die ausgewählte Wortleitung (WL5) wenigstens während eines Zeitintervalls, das das Erhöhen der Spannung des ersten und des zweiten Bereichs enthält;
wobei das Erhöhen der Spannung des zweiten Bereichs des Substrats (490) während des Anlegens der Programmierspannung an die ausgewählte Wortleitung (WL5) fortgesetzt wird.

5. Verfahren nach einem vorhergehenden Anspruch,
wobei das Erhöhen der Spannung des ersten und des zweiten Bereichs in Verbindung mit dem Programmieren des wenigstens einen nichtflüchtigen Speicherelements (418) über die ausgewählte Wortleitung (WL5) ausgeführt wird und die ausgewählte Wortleitung sich in einer vorgegebenen Gruppe von Wortleitungen der Menge von Wortleitungen, die zu einer Drain-Seite der Menge nichtflüchtiger Speicherelemente benachbart ist, befindet; und
das Erhöhen der Spannung von Source- und Drain-seitigen Bereichen einer anschließend ausgewählten Wortleitung in Verbindung mit dem Programmieren wenigstens eines zusätzlichen nichtflüchtigen Speicherelements über die anschließend ausgewählte Wortleitung konkurrent begonnen wird, wobei sich die anschließend ausgewählte Wortleitung nicht in der vorgegebenen Menge von Wortleitungen befindet.

6. Verfahren nach Anspruch 5, wobei
die vorgegebene Gruppe von Wortleitungen ungefähr 25 % der Wortleitungen der Menge von Wortleitungen enthält.

7. Nichtflüchtiges Speichersystem mit einer NAND-Flash-Speicherstruktur, das enthält:
eine Menge nichtflüchtiger Speicherelemente (406, 408, ..., 422; 1000) wenigstens teilweise auf einem Substrat (490) ausgebildet ist;
eine Menge von Wortleitungen (WL0, WL1, ..., WL7), der die Menge nichtflüchtiger Speicherelemente zugeordnet ist, eine ausgewählte Wortleitung (WL5) enthält, die wenigstens einem nichtflüchtigen Speicherelement (418) der Menge nichtflüchtiger Speicherelemente zugeordnet ist; und
eine oder mehrere Steuerschaltungen (1250) mit der Menge nichtflüchtiger Speicherelemente (1100) kommunizieren;
wobei die eine oder die mehreren Steuerschaltungen dazu ausgelegt sind, die Spannung eines ersten Bereichs des Substrats (490) auf einer Source-Seite des wenigstens einen nichtflüchtigen Speicherelements, das der ausgewählten Wortleitung (WL5) zugeordnet ist, zu erhöhen bzw. zu boosten, die Spannung eines zweiten Bereichs des Substrats (490) auf einer Drain-Seite des wenigstens einen nichtflüchtigen Speicherelements, das der ausgewählten Wortleitung (WL5) zugeordnet ist, zu erhöhen und während des Erhöhens der Spannung des ersten und des zweiten Bereichs an wenigstens eine Wortleitung (WL2) der Menge von Wortleitungen auf der Source-Seite des wenigstens einen nichtflüchtigen Speicherelements, das der ausgewählten Wortleitung (WL5) zugeordnet ist, eine Isolierspannung anzulegen;
**dadurch gekennzeichnet, dass**:
die eine oder die mehreren Steuerschaltungen (1250) dazu ausgelegt sind, das Erhöhen der Spannung des ersten Bereichs in Bezug auf das Erhöhen der Spannung des zweiten Bereichs früher zu beginnen.

8. Nichtflüchtiges Speichersystem nach Anspruch 7, wobei:
die eine oder die mehreren Steuerschaltungen (1250) dazu ausgelegt sind, die Spannung des ersten Bereichs durch Anlegen einer Durchlassspannung an wenigstens eine Wortleitung (WL0, WL1) der Menge von Wortleitungen auf der Source-Seite der ausgewählten Wortleitung zu erhöhen und die Spannung des zweiten Bereichs durch Anlegen einer Durchlassspannung an wenigstens eine andere Wortleitung (WL6, WL7) der Menge von Wortleitungen auf der Drain-Seite der ausgewählten Wortleitung zu erhöhen.

9. Nichtflüchtiges Speichersystem nach Anspruch 7 oder 8, wobei:
die Menge nichtflüchtiger Speicherelemente (406, 408, ..., 422; 1000) in wenigstens einer NAND-Kette vorgesehen ist, die sich zwischen einem Auswahl-Gate (406) auf Seiten der Source und einem Auswahl-Gate (424) auf Seiten des Drains befindet; und
die eine oder die mehreren Steuerschaltungen (1250) dazu ausgelegt sind, das Auswahl-Gate (406) auf Seiten der Source und das Auswahl-Gate (424) auf Seiten des Drains während des Erhöhens der Spannungen des ersten und des zweiten Bereichs geschlossen zu halten.

10. Nichtflüchtiges Speichersystem nach einem der Ansprüche 7 bis 9, wobei:
die eine oder die mehreren Steuerschaltungen (1250) dazu ausgelegt sind, an das wenigstens eine nichtflüchtige Speicherelement (418) über die ausgewählte Wortleitung (WL5) wenigstens während eines Teils eines Zeitintervalls, das das Erhöhen der Spannung des ersten und des zweiten Bereichs enthält, eine Programmierspannung anzulegen; und
die eine oder die mehreren Steuerschaltungen (1250) ferner dazu ausgelegt sind, das Erhöhen der Spannung des zweiten Bereichs des Substrats (490) während des Anlegens der Programmierspannung an die ausgewählte Wortleitung (WL5) fortzusetzen.

11. Nichtflüchtiges Speichersystem nach einem der Ansprüche 7 bis 10, wobei:
die eine oder die mehreren Steuerschaltungen (1250) dazu ausgelegt sind, das Erhöhen der Spannung des ersten und des zweiten Bereichs in Verbindung mit dem Programmieren des wenigstens einen nichtflüchtigen Speicherelements (418) über die ausgewählte Wortleitung (WL5) auszuführen, wobei sich die ausgewählte Wortleitung in einer vorgegebenen Gruppe von Wortleitungen der Menge von Wortleitungen, die zu einer Drain-Seite der Menge nichtflüchtiger Speicherelemente benachbart ist, befindet; und
die eine oder die mehreren Steuerschaltungen ferner dazu ausgelegt sind, konkurrent das Erhöhen der Spannung von Source- und Drain-seitigen Bereichen einer anschließend ausgewählten Wortleitung in Verbindung mit dem Programmieren wenigstens eines zusätzlichen nichtflüchtigen Speicherelements über die anschließend ausgewählte Wortleitung zu beginnen, wobei sich die anschließend ausgewählte Wortleitung nicht in der vorgegebenen Menge von Wortleitungen befindet.

12. Nichtflüchtiges Speichersystem nach Anspruch 11, wobei:
die vorgegebene Gruppe von Wortleitungen ungefähr 25 % der Wortleitungen der Menge von Wortleitungen enthält.

## Revendications

1. Procédé de programmation d'une mémoire non volatile ayant une structure de mémoire flash NON-ET, comprenant les opérations consistant :
à amplifier une première région d'un substrat (490), un ensemble d'éléments de mémoire non volatile (406, 408, ..., 422) étant formé, au moins en partie, sur le substrat, l'ensemble d'éléments de mémoire non volatile étant associé à un ensemble de lignes de mots (WL0, WL2,..., WL7) et comportant au moins un élément de mémoire non volatile (418) associé à une ligne de mots (WL5), sélectionnée, du groupe de lignes de mots, la première région étant sur un côté source du ou des éléments de mémoire non volatile, au moins au nombre de un, associés à la ligne de mots (WL5) sélectionnée ;
à amplifier une seconde région du substrat située sur un côté drain du ou des éléments de mémoire non volatile, au moins au nombre de un, associés à la ligne de mots (WL5) sélectionnée ; et
pendant l'amplification des première et seconde régions, à appliquer une tension d'isolement à au moins une ligne de mots (WL2) située dans l'ensemble de lignes de mots sur le côté source du ou des éléments de mémoire non volatile, au moins au nombre de un, associés à la ligne de mots (WL5) sélectionnée ;
**caractérisé en ce que** :
l'amplification de la première région a lieu antérieurement vis-à-vis de l'amplification de la seconde région.

2. Procédé selon la revendication 1, selon lequel :
l'amplification de la première région comprend l'opération consistant à appliquer une tension de passage à au moins une ligne de mots (WL0 , WL1) située dans l'ensemble de lignes de mots sur le côté source de la ligne de mots sélectionnée, et l'amplification de la seconde région comprend l'opération consistant à appliquer une tension de passage à au moins une autre ligne de mots (WL6, WL7) située dans l'ensemble de lignes de mots sur le côté drain de la ligne de mots sélectionnée.

3. Procédé selon la revendication 1 ou 2, selon lequel :
l'ensemble d'éléments de mémoire non volatile (406, 408,..., 422) est prévu en au moins une chaîne NON-ET qui s'étend entre une porte de sélection (406) côté source et une porte de sélection (424) côté drain;
le procédé comprenant en outre l'opération consistant :
à maintenir la porte de sélection (406) côté source et la porte de sélection (424) côté drain fermées pendant l'amplification des première et seconde régions.

4. Procédé selon l'une quelconque des revendications précédentes, comprenant en outre l'opération consistant :
à appliquer une tension de programme à l'élément ou aux éléments de mémoire non volatile (418), au moins au nombre de un, par l'intermédiaire de la ligne de mots (WL5) sélectionnée, pendant au moins une partie d'une période de temps impliquant l'amplification des première et seconde régions ;
dans lequel l'amplification de la seconde région du substrat (490) se poursuit pendant l'application de la tension de programme sur la ligne de mots (WL5) sélectionnée.

5. Procédé selon l'une quelconque des revendications précédentes, selon lequel l'amplification des première et seconde régions est effectuée en liaison avec une programmation de l'élément ou des éléments de mémoire non volatile (418), au moins au nombre de un, par l'intermédiaire de la ligne de mots (WL5) sélectionnée, et la ligne de mots sélectionnée est parmi un groupe préfixé de lignes de mots, de l'ensemble de lignes de mots, qui est adjacent à un côté drain de l'ensemble d'éléments de mémoire non volatile,
le procédé comprenant en outre l'opération consistant :
à initier concurremment une amplification des régions côté drain et côté source d'une ligne de mots sélectionnée postérieurement, en liaison avec une programmation d'au moins un élément de mémoire non volatile supplémentaire, par l'intermédiaire de la ligne de mots sélectionnée postérieurement, la ligne de mots sélectionnée postérieurement n'étant pas parmi le groupe préfixé de lignes de mots.

6. Procédé selon la revendication 5, selon lequel :
le groupe préfixé de lignes de mots comprend approximativement 25% des lignes de mots de l'ensemble de lignes de mots.

7. Système de mémoire non volatile ayant une structure de mémoire flash NON-ET, comprenant :
un ensemble d'éléments de mémoire non volatile (406, 408, ..., 422 ; 1000) formé, au moins en partie, sur un substrat (490) ;
un ensemble de lignes de mots (WL0, WL1,..., WL7) associé à l'ensemble d'éléments de mémoire non volatile, comportant une ligne de mots (WL5) sélectionnée qui est associée à au moins un élément de mémoire non volatile (418) de l'ensemble d'éléments de mémoire non volatile ; et
un ou plusieurs circuits de commande (1250) en communication avec l'ensemble d'éléments de mémoire non volatile (1100) ;
dans lequel le ou les circuits de commande sont agencés de façon à amplifier une première région du substrat (490) située sur un côté source de l'élément ou des éléments de mémoire non volatile, au moins au nombre de un, associés à la ligne de mots (WL5) sélectionnée, à amplifier une seconde région du substrat (490) située sur un côté drain de l'élément ou des éléments de mémoire non volatile, au moins au nombre de un , associés à la ligne de mots (WL5) sélectionnée, et, pendant l'amplification des première et seconde régions, à appliquer une tension d'isolement à au moins une ligne de mots (WL2) située dans l'ensemble de lignes de mots sur le côté source de l'élément ou des éléments de mémoire non volatile, au moins au nombre de un, associés à la ligne de mots (WL5) sélectionnée ;
**caractérisé en ce que** :
le ou les circuits de commande (1250) sont agencés de façon à initier l'amplification de la première région antérieurement vis-à-vis de l'amplification de la seconde région.

8. Système de mémoire non volatile selon la revendication 7, dans lequel :
le ou les circuits de commande (1250) sont agencés de façon à amplifier la première région en appliquant une tension de passage à au moins une ligne de mots (WL0 , WL1) située dans l'ensemble de lignes de mots sur le côté source de la ligne de mots sélectionnée, et à amplifier la seconde région en appliquant une tension de passage à au moins une autre ligne de mots (WL6, WL7) située dans l'ensemble de lignes de mots sur le côté drain de la ligne de mots sélectionnée.

9. Système de mémoire non volatile selon la revendication 7 ou 8, dans lequel :
l'ensemble d'éléments de mémoire non volatile (406, 408,..., 422 ; 1000) est prévu en au moins une chaîne NON-ET qui s'étend entre une porte de sélection (406) côté source et une porte de sélection (424) côté drain ; et
le ou les circuits de commande (1250) sont agencés de façon à maintenir la porte de sélection (406) côté source et la porte de sélection (424) côté drain fermées pendant l'amplification des première et seconde régions.

10. Système de mémoire non volatile selon l'une quelconque des revendications 7 à 9, dans lequel :
le ou les circuits de commande (1250) sont agencés de façon à appliquer une tension de programmation à l'élément ou aux éléments de mémoire non volatile (418), au moins au nombre de un, par l'intermédiaire de la ligne de mots (WL5) sélectionnée, pendant au moins une partie d'une période de temps impliquant l'amplification des première et seconde régions ; et
le ou les circuits de commande (1250) sont en outre agencés de façon à poursuivre l'amplification de la seconde région du substrat (490) pendant l'application de la tension de programmation sur la ligne de mots (WL5) sélectionnée.

11. Système de mémoire non volatile selon l'une quelconque des revendications 7 à 10, dans lequel :
le ou les circuits de commande (1250) sont agencés de façon à effectuer l'amplification des première et seconde régions en liaison avec une programmation de l'élément ou des éléments de mémoire non volatile (418), au moins au nombre de un, par l'intermédiaire de la ligne de mots (WL5) sélectionnée, la ligne de mots sélectionnée étant parmi un groupe préfixé de lignes de mots, de l'ensemble de lignes de mots, qui est adjacent à un côté drain de l'ensemble d'éléments de mémoire non volatile ; et
le ou les circuits de commande (1250) sont en outre agencés de façon à initier concurremment une amplification des régions côté drain et côté source d'une ligne de mots sélectionnée postérieurement, en liaison avec une programmation d'au moins un élément de mémoire non volatile supplémentaire, par l'intermédiaire de la ligne de mots sélectionnée postérieurement, la ligne de mots sélectionnée postérieurement n'étant pas parmi le groupe préfixé de lignes de mots.

12. Système de mémoire non volatile selon la revendication 11, dans lequel :
le groupe préfixé de lignes de mots comprend approximativement 25% des lignes de mots de l'ensemble de lignes de mots.
